# EUROPEAN PATENT APPLICATION

(11) **EP 2 851 935 A1**
(43) Date of publication of application: **25.03.2015**
(21) Application number: 14178087.4
(22) Date of filing: 22.07.2014
(51) Int. Cl.: H01L 21/04, H01L 21/02, H01L 29/66

(54) **Method of manufacturing semiconductor device**

(30) Priority: 20.09.2013 JP 2013194769
(71) Applicant: Kabushiki Kaisha Toshiba, Tokyo 105-8001 (JP)
(72) Inventor: Nishio, Johji, Minato-ku, Tokyo 105-8001 (JP); Shimizu, Tatsuo, Minato-ku, Tokyo 105-8001 (JP); Ota, Chiharu, Minato-ku, Tokyo 105-8001 (JP); Iljima, Ryosuke, Minato-ku, Tokyo 105-8001 (JP); Shinohe, Takashi, Minato-ku, Tokyo 105-8001 (JP)
(74) Representative: Granleese, Rhian Jane

(57) **Abstract**

A method of manufacturing a semiconductor device of an embodiment includes: preparing a substrate; and growing a p-type SiC single-crystal layer on the surface of the substrate from a liquid phase that contains Si (silicon), C (carbon), a p-type impurity, and an n-type impurity, the p-type impurity being an element A, the n-type impurity being an element D, the element A and the element D forming a first combination that is at least one combination selected from Al (aluminum) and N (nitrogen), Ga (gallium) and N (nitrogen), and In (indium) and N (nitrogen), and/or a second combination of B (boron) and P (phosphorus), the ratio of the concentration of the element D to the concentration of the element A in the first or second combination being higher than 0.33 but lower than 1.0.

## Description

### RELATED APPLICATION

This application is based upon and claims the benefit of priority from Japanese Patent Application No. 2013-194769, filed on September 20, 2013.

### FIELD

Embodiments described herein relate generally to a method of manufacturing a semiconductor device.

### BACKGROUND

SiC (silicon carbide) is expected to be a material for next-generation power semiconductor devices. SiC has excellent physical properties, having a band gap three times wider than that of Si (silicon), a breakdown field strength approximately 10 times higher than that of Si, and a heat conductivity approximately three times higher than that of Si. A power semiconductor device that has low loss and is capable of high-temperature operation can be realized by taking advantage of those properties.

Meanwhile, it is known that dislocations such as threading screw dislocations (TSDs) or basal plane dislocations (BPDs) in SiC single crystals degrade device characteristics.

### BRIEF DESCRIPTION OF THE DRAWINGS

FIG. 1 is a schematic cross-sectional view of a semiconductor device of a first embodiment;
FIG. 2 is a flowchart showing a method of manufacturing the semiconductor device of the first embodiment;
FIG. 3 is a schematic cross-sectional view illustrating the method of manufacturing the semiconductor device of the first embodiment;
FIG. 4 is a schematic cross-sectional view of the liquid phase growth apparatus used by the manufacturing method according to the first embodiment;
FIG. 5 is a schematic cross-sectional view illustrating the method of manufacturing the semiconductor device of the first embodiment;
FIG. 6 is a schematic cross-sectional view illustrating the method of manufacturing the semiconductor device of the first embodiment;
FIG. 7 is a schematic cross-sectional view illustrating the method of manufacturing the semiconductor device of the first embodiment;
FIG. 8 is a schematic cross-sectional view illustrating the method of manufacturing the semiconductor device of the first embodiment;
FIG. 9 is a diagram for explaining the function of the method of manufacturing the semiconductor device of the first embodiment;
FIG. 10 is a diagram for explaining the function of co-doping;
FIG. 11 is a diagram for explaining the function of co-doping;
FIG. 12 is a diagram for explaining the function of co-doping;
FIG. 13 is a diagram for explaining the function of co-doping;
FIG. 14 is a diagram for explaining the function of co-doping;
FIG. 15 is a diagram showing the relationship between Al and N densities and sheet resistance in the case of n-type SiC;
FIG. 16 is a diagram showing the relationship between N and Al densities and sheet resistance in the case of p-type SiC;
FIG. 17 is a schematic cross-sectional view of a semiconductor device of a second embodiment;
FIG. 18 is a flowchart showing a method of manufacturing the semiconductor device of the second embodiment;
FIG. 19 is a schematic cross-sectional view illustrating the method of manufacturing the semiconductor device of the second embodiment;
FIG. 20 is a schematic cross-sectional view illustrating the method of manufacturing the semiconductor device of the second embodiment;
FIG. 21 is a schematic cross-sectional view of a semiconductor device of a third embodiment;
FIG. 22 is a flowchart showing a method of manufacturing the semiconductor device of the third embodiment;
FIG. 23 is a schematic cross-sectional view illustrating the method of manufacturing the semiconductor device of the third embodiment;
FIG. 24 is a schematic cross-sectional view illustrating the method of manufacturing the semiconductor device of the third embodiment;
FIG. 25 is a schematic cross-sectional view of a semiconductor device of a fourth embodiment;
FIG. 26 is a flowchart showing a method of manufacturing the semiconductor device of the fourth embodiment;
FIG. 27 is a schematic cross-sectional view illustrating the method of manufacturing the semiconductor device of the fourth embodiment;
FIG. 28 is a schematic cross-sectional view illustrating the method of manufacturing the semiconductor device of the fourth embodiment;
FIG. 29 is a schematic cross-sectional view of a semiconductor device of a fifth embodiment;
FIG. 30 is a flowchart showing a method of manufacturing the semiconductor device of the fifth embodiment; and
FIG. 31 is a schematic cross-sectional view illustrating the method of manufacturing the semiconductor device of the fifth embodiment.

### DETAILED DESCRIPTION

A method of manufacturing a semiconductor device of an embodiment includes: preparing a substrate; and growing a p-type SiC single-crystal layer on the surface of the substrate from a liquid phase that contains Si (silicon), C (carbon), a p-type impurity, and an n-type impurity, the p-type impurity being an element A, the n-type impurity being an element D, the element A and the element D forming a first combination that is at least one combination selected from Al (aluminum) and N (nitrogen), Ga (gallium) and N (nitrogen), and In (indium) and N (nitrogen), and/or a second combination of B (boron) and P (phosphorus), the ratio of the concentration of the element D to the concentration of the element A in the first combination or in the second combination being higher than 0.33 but lower than 1.0.

The following is a description of embodiments, with reference to the accompanying drawings. In the following description, like components are denoted by like reference numerals, and explanation of components described once will not be repeated.

In the following description, n⁺, n, n⁻, p⁺, p, and p⁻ indicate relative levels of impurity densities in the respective conductivity types. Specifically, the concentration of an n⁺-type impurity is relatively higher than the concentration of the corresponding n-type impurity, and the concentration of an n⁻-type impurity is relatively lower than the concentration of the corresponding n-type impurity. Likewise, the concentration of a p⁺-type impurity is relatively higher than the concentration of the corresponding p-type impurity, and the concentration of a p⁻-type impurity is relatively lower than the concentration of the corresponding p-type impurity. It should be noted that there are cases where an n⁺ type and an n- type are referred to simply as an n-type, and a p⁺ type and a p⁻ type are referred to simply as a p-type.

### (First Embodiment)

A method of manufacturing a semiconductor device of this embodiment includes: preparing a substrate; and growing a p-type SiC single-crystal layer on the surface of the substrate from a liquid phase that contains Si (silicon), C (carbon), a p-type impurity, and an n-type impurity, the p-type impurity being an element A, the n-type impurity being an element D, the element A and the element D forming a first combination that is at least one combination selected from Al (aluminum) and N (nitrogen), Ga (gallium) and N (nitrogen), and In (indium) and N (nitrogen), and/or a second combination of B (boron) and P (phosphorus), the ratio of the concentration of the element D to the concentration of the element A in the first or second combination being higher than 0.33 but lower than 1.0, the concentration of the element A in the combination being not lower than 1 × 10¹⁶ cm⁻³ and not higher than 1 × 10²² cm⁻³.

More particularly, an n-type SiC layer is formed on the surface of the SiC single-crystal layer through epitaxial growth, a p-type first SiC region is formed in the surface of the SiC layer, an n-type second SiC region is formed in the surface of the first SiC region, a p-type third SiC region is formed in the surface of the first SiC region, a gate insulating film is formed on the surfaces of the SiC layer and the first SiC region, a gate electrode is formed on the gate insulating film, a first electrode connected to the second SiC region and the third SiC region is formed, and a second electrode connected to the SiC single-crystal layer is formed.

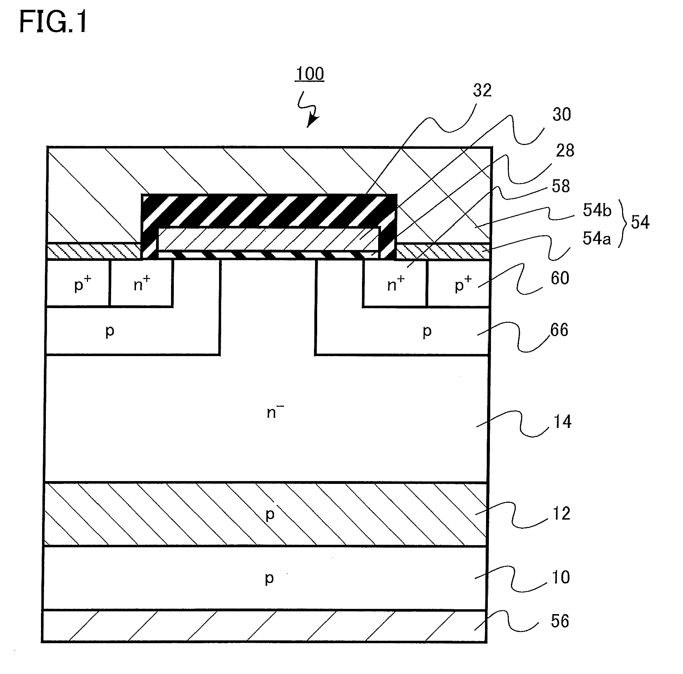

FIG. 1 is a schematic cross-sectional view of the structure of an IGBT (Insulated Gate Bipolar Transistor) that is manufactured by a method of manufacturing a semiconductor device of this embodiment.

This IGBT 100 includes a p-type SiC single-crystal substrate 10. This p-type SiC single-crystal substrate 10 is a 4H-SiC substrate (a p-SiC single-crystal substrate) that contains Al (aluminum), for example, as the p-type impurity at an impurity concentration that is not lower than approximately 1 × 10¹⁸ cm⁻³ and not higher than approximately 1 × 10²² cm⁻³.

A p-type SiC single-crystal layer (a p-SiC single-crystal layer) 12 formed by a liquid phase growth technique is provided on the p-type SiC single-crystal substrate 10. The p-type SiC single-crystal layer 12 is co-doped with the p-type impurity and the n-type impurity. Where the p-type impurity is an element A and the n-type impurity is an element D, the element A and the element D form a first combination selected from Al (aluminum) and N (nitrogen), Ga (gallium) and N (nitrogen), and In (indium) and N (nitrogen), and/or a second combination of B (boron) and P (phosphorus). The ratio of the concentration of the element D to the concentration of the element A in the first or second combination (concentration D/concentration A) is higher than 0.33 but lower than 1.0. In this embodiment, the concentration of the element A forming part of the above combination is not lower than 1 × 10¹⁸ cm⁻³ and not higher than 1 × 10²² cm⁻³.

In the case of the first combination of Al (aluminum) and N (nitrogen), Ga (gallium) and N (nitrogen), or In (indium) and N (nitrogen), for example, the element A may be a single element selected from Al (aluminum), Ga (gallium), and In (indium). Alternatively, the element A may be formed with two elements such as Al (an element A₁) and Ga (an element A₂) or may be formed with three elements such as Al (the element A₁), Ga (the element A₂), and In (an element A₃). In a case where the element A is formed with more than one element, the element A may be formed with two or three kinds of elements, as long as the above described conditions on the ratio of the concentration of the element D to the concentration of the element A and on the concentration of the element A are satisfied.

The first combination and the second combination can coexist. However, the above described conditions on the ratio of the concentration of the element D to the concentration of the element A and on the concentration of the element A should be satisfied with elements that form at least one of the first and second combinations. In other words, each of the first combination and the second combination should satisfy the conditions on the element ratio and the element concentration. This is because the later described trimers are not formed between an impurity in the first combination and an impurity in the second combination.

In a case where the Al concentration is 1 × 10¹⁸ cm⁻³, the Ga concentration is 1 × 10¹⁸ cm⁻³, and the N concentration is 1 × 10¹⁸ cm⁻³, for example, N/(Al + Ga) is 0.5, and (Al + Ga) is 2 × 10¹⁸ cm⁻³. In this case, the element ratio and the element densities are within the ranges set by this embodiment.

In a case where the B concentration is 4 × 10¹⁸ cm⁻³, the P concentration is 1 × 10¹⁸ cm³, and the N concentration is 1 × 10¹⁸ cm⁻³, for example, attention is paid only to B and P, which forms the second combination. As a result, P/B is 0.25, which does not satisfy the element ratio condition, and is outside the range set by this embodiment.

Also, in a case where the Al concentration is 5 × 10¹⁷ cm⁻³, the B concentration is 5 × 10¹⁷ cm⁻³, the N concentration is 2.5 × 10¹⁷ cm⁻³, and the P concentration is 2.5 × 10¹⁷ cm⁻³, N/Al is 0.5, which satisfies the ratio condition, but the Al concentration is lower than 1 × 10¹⁸ cm⁻³ in the first combination. In the second combination, P/B is 0.5, which satisfies the ratio condition, but the B concentration is lower than 1 × 10¹⁸ cm⁻³. Therefore, either of the first and second combinations does not satisfy the element ratio condition and the element concentration condition, and is outside the ranges set by this embodiment.

It should be noted that this embodiment does not exclude elements other than the above mentioned elements as p-type impurities and n-type impurities. In the following, an example case where the element A is Al (aluminum) and the element D is N (nitrogen) is described.

The Al concentration in the p-SiC single-crystal layer 12 is not lower than 1 × 10¹⁸ cm⁻³ and not higher than 1 × 10²² cm⁻³. The thickness of the p-SiC single-crystal layer 12 is not smaller than 1 µm and not greater than 350 µm, for example.

An n-type SiC layer (an n⁻-SiC layer) 14 containing the n-type impurity at an impurity concentration that is not lower than 5 × 10¹⁵ cm⁻³ and not higher than 2 × 10¹⁶ cm⁻³, for example, is formed on the surface of the p-SiC single-crystal layer 12. The thickness of the n⁻-SiC layer 14 is not smaller than 5 µm and not greater than 120 µm, for example.

A p-type first SiC region (a first emitter region) 66 containing the p-type impurity at an impurity concentration that is not lower than 5 × 10¹⁵ cm⁻³ and not higher than 1 × 10¹⁷ cm⁻³, for example, is formed in part of the surface of the n⁻-SiC layer 14. The depth of the first emitter region 66 is approximately 0.6 µm, for example.

An n⁺-type second SiC region (a second emitter region) 58 containing the n-type impurity at an impurity concentration that is not lower than 1 × 10¹⁸ cm⁻³ and not higher than 1 × 10²² cm³, for example, is formed in part of the surface of the first SiC region (the first emitter region) 66. The depth of the second emitter region 58 is smaller than the depth of the first SiC region (the first emitter region) 66, and is approximately 0.3 µm, for example.

A p⁺-type third SiC region (an emitter contact region) 60 containing the p-type impurity at an impurity concentration that is not lower than 1 × 10¹⁸ cm⁻³ and not higher than 1 × 10²² cm⁻³, for example, is formed in part of the surface of the first SiC region (the first emitter region) 66 and on a side of the n⁺-type second SiC region (the second emitter region) 58. The depth of the emitter contact region 60 is smaller than the depth of the first SiC region (the first emitter region) 66, and is approximately 0.3 µm, for example.

A gate insulating film 28 is continuously formed on the surfaces of the n⁻-SiC layer 14 and the first SiC region (the first emitter region) 66, so as to bridge the space between the layer and the region. The gate insulating film 28 may be a silicon oxide film (a SiO₂ film), a silicon oxynitride film, or a high-k insulating film, for example.

A gate electrode 30 is formed on the gate insulating film 28. The gate electrode 30 may be made of polysilicon, for example. An interlayer insulating film 32 formed with a SiO₂ film, for example, is formed on the gate electrode 30.

The first SiC region 66 that is located below the gate electrode 30 and is interposed between the second SiC region (the second emitter region) 58 and the n⁻-SiC layer 14 serves as the channel region.

A conductive first electrode (an emitter electrode) 54 that is electrically connected to the second SiC region (the second emitter region) 58 and the third SiC region (the emitter contact region) 60 is provided. The first electrode (the emitter electrode) 54 is formed with a Ni (nickel) barrier metal layer 54a and an Al metal layer 54b formed on the barrier metal layer 54a, for example. The Ni barrier metal layer 54a and the Al metal layer 54b may form an alloy through a reaction.

A conductive second electrode (a collector electrode) 56 is formed on the bottom surface of the p-SiC single-crystal substrate 10. The second electrode (the collector electrode) 56 is made of Ni, for example.

Next, a method of manufacturing the semiconductor device of this embodiment is described.

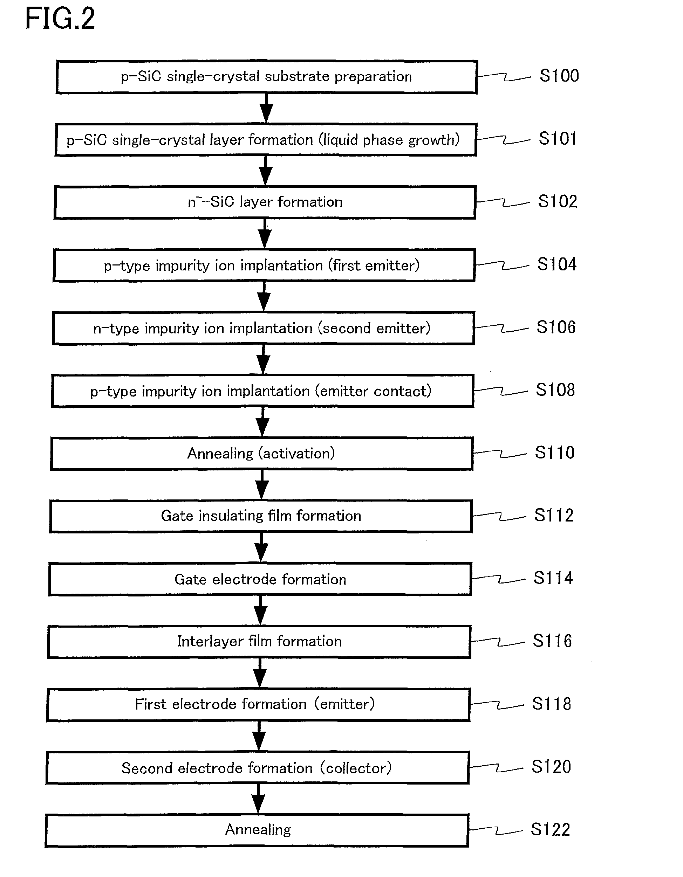

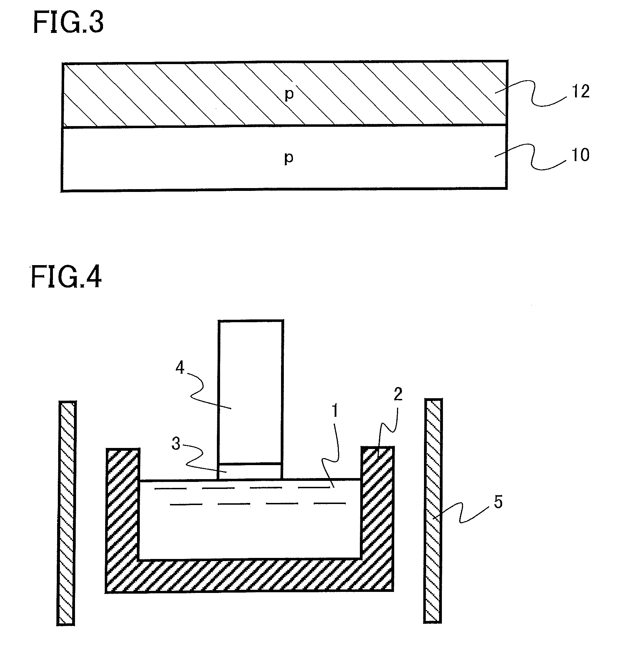

FIG. 2 is a flowchart showing an example of the method of manufacturing the semiconductor device of this embodiment. FIG. 3 and FIGS. 5 through 8 are schematic cross-sectional views illustrating the method of manufacturing the semiconductor device of this embodiment. FIG. 4 is a schematic cross-sectional view of the liquid phase growth apparatus used by the manufacturing method according to this embodiment.

As shown in FIG. 2, the method of manufacturing the semiconductor device includes: p-SiC single-crystal substrate preparation (step S100); p-SiC single-crystal layer formation by a liquid phase growth technique (step S101); n⁻-SiC layer formation (step S102); p-type impurity ion implantation (step S104); n-type impurity ion implantation (step S106); p-type impurity ion implantation (step S108); annealing (step S110); gate insulating film formation (step S112); gate electrode formation (step S114); interlayer film formation (step S116); first electrode formation (step S118); second electrode formation (step S120); and annealing (step S122).

First, in step S100, the 4H-SiC p-type SiC single-crystal substrate (the p-SiC single-crystal substrate) 10 that contains Al (aluminum) as the p-type impurity at an impurity concentration of approximately 5 × 10¹⁸ cm⁻³, has low resistance, and has a thickness of 200 µm, for example, is prepared.

In step S101, the p-type SiC single-crystal layer 12 is formed on the surface of the p-SiC single-crystal substrate 10 through epitaxial growth by a liquid phase growth technique (FIG. 3). The surface of the p-SiC single-crystal substrate 10 has an off angle that is not smaller than 0.5 degrees and not larger than 8 degrees with respect to the {0001} plane, for example.

FIG. 4 is a schematic cross-sectional view of the liquid phase growth apparatus used for forming the p-type SiC single-crystal layer 12. The liquid phase growth apparatus includes a crucible 2 that stores a liquid phase 1, a supporting unit 4 that is capable of supporting a seed crystal 3 at its end portion, and a heater 5 that heats the liquid phase 1 and the seed crystal 3. The crucible 2 is made of graphite, for example.

In step S101, at the supporting unit 4, the p-SiC single-crystal substrate 10 is secured as the seed crystal 3 to the end portion of the supporting unit 4. The liquid phase 1 in the crucible 2 is heated to a temperature that is not lower than 1800°C and not higher than 2100°C, for example, by the heater 5. The liquid phase 1 contains Si (silicon), C (carbon), the p-type impurity, and the n-type impurity. Where the p-type impurity is an element A and the n-type impurity is an element D, the element A and the element D form a first combination selected from Al (aluminum) and N (nitrogen), Ga (gallium) and N (nitrogen), and In (indium) and N (nitrogen), and/or a second combination of B (boron) and P (phosphorus). The ratio of the concentration of the element D to the concentration of the element A in the first or second combination is higher than 0.33 but lower than 1.0. In this embodiment, the element A is Al, and the element D is N.

The surface of the p-SiC single-crystal substrate 10 is immersed in the liquid phase 1, to form the p-type SiC single-crystal layer (the p-SiC single-crystal layer) 12 on the surface of the p-SiC single-crystal substrate 10 through epitaxial growth from the liquid phase 1.

The formed p-SiC single-crystal layer 12 is co-doped with the p-type impurity and the n-type impurity. Where the p-type impurity is an element A and the n-type impurity is an element D, the element A and the element D form a first combination that is at least one combination selected from Al (aluminum) and N (nitrogen), Ga (gallium) and N (nitrogen), and In (indium) and N (nitrogen), and/or a second combination of B (boron) and P (phosphorus). The ratio of the concentration of the element D to the concentration of the element A in the first or second combination (concentration D/concentration A) is higher than 0.33 but lower than 1.0. In this embodiment, the element A is Al, and the element D is N.

The Al concentration in the p-SiC single-crystal layer 12 is not lower than 1 × 10¹⁸ cm⁻³ and not higher than 1 × 10²² cm⁻³, for example. The densities of the p-type impurity and the n-type impurity in the p-SiC single-crystal layer 12 can be adjusted to desired values by controlling the densities of the p-type impurity and the n-type impurity in the liquid phase 1.

The thickness of the p-SiC single-crystal layer 12 is not smaller than 1 µm and not greater than 350 µm, for example.

In step S102, the high-resistance n⁻-SiC layer 14 that contains N as the n-type impurity at an impurity concentration of approximately 1 × 10¹⁶ cm⁻³, for example, and has a thickness of approximately 100 µm is grown on the surface of the p-SiC single-crystal layer 12 by an epitaxial growth technique.

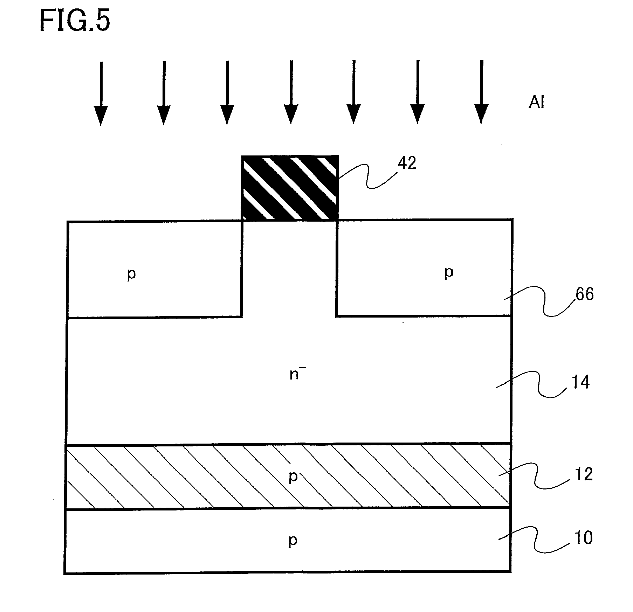

After that, patterning is performed by photolithography and etching, to form a first mask material 42 that is made of SiO₂, for example. In step S104, Al as the p-type impurity is implanted into the n⁻-SiC layer 14 through ion implantation by using the first mask material 42 as an ion implantation mask, to form the first SiC region (the first emitter region) 66 (FIG. 5).

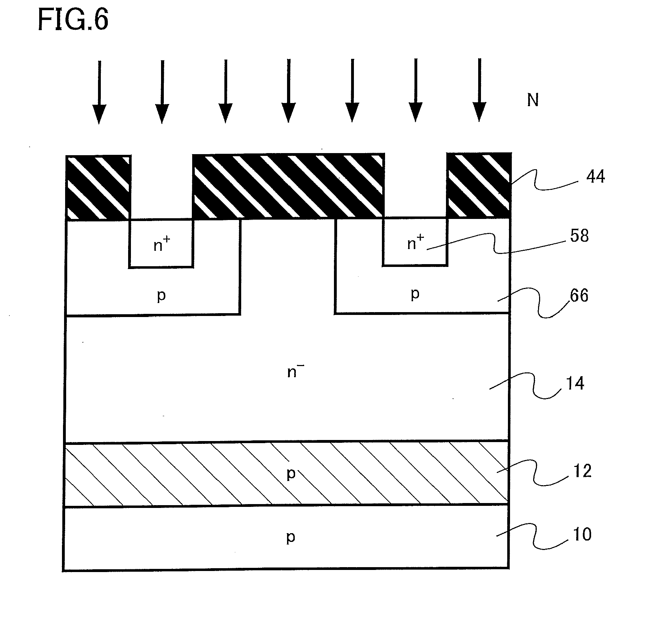

After that, patterning is performed by photolithography and etching, to form a second mask material 44 that is made of SiO₂, for example. In step S106, N as the n-type impurity is implanted into the n⁻-SiC layer 14 through ion implantation by using the second mask material 44 as an ion implantation mask, to form the n-type second SiC region (the second emitter region) 58 (FIG. 6).

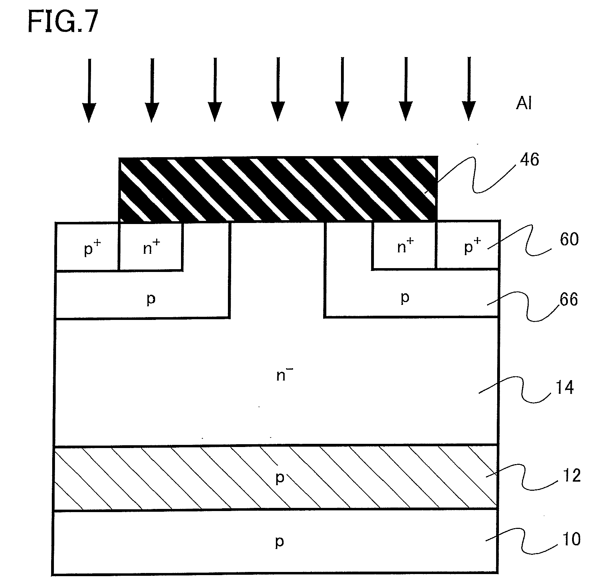

After that, patterning is performed by photolithography and etching, to form a third mask material 46 that is made of SiO₂, for example. In step S108, Al as the p-type impurity is implanted into the n⁻-SiC layer 14 through ion implantation by using the third mask material 46 as an ion implantation mask, to form the p-type third SiC region (the emitter contact region) 60 (FIG. 7).

In step S110, annealing is performed to activate the p-type impurity and the n-type impurity that have been ion-implanted. The conditions for the annealing are that an argon (Ar) gas is used as the atmosphere gas, the heating temperature is 1600°C, and the heating period is 30 minutes, for example. At this point, the impurities implanted into the SiC can be activated, but diffusion is small.

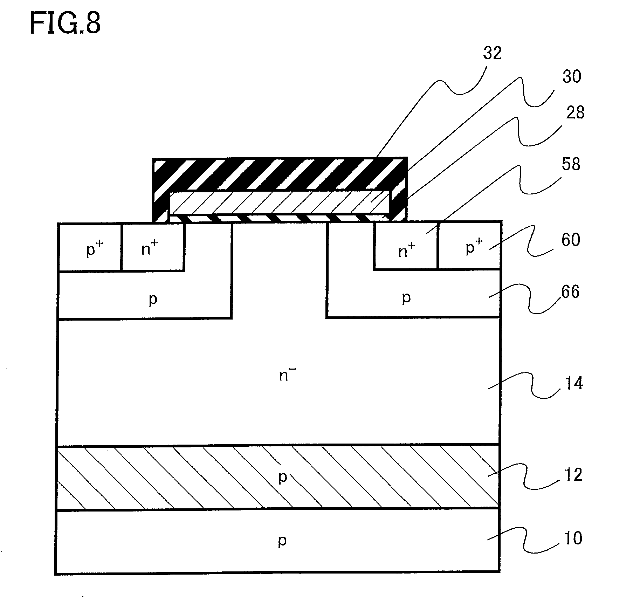

In step S112, the gate insulating film 28 that is formed with a SiO₂ film, for example, is formed by CVD (Chemical Vapor Deposition) or thermal oxidation. In step S114, the gate electrode 30 that is made of polysilicon, for example, is formed on the gate insulating film 28. In step S116, the interlayer insulating film 32 that is formed with a SiO₂ film, for example, is formed on the gate electrode 30 (FIG. 8).

After that, in step S118, the conductive first electrode (the emitter electrode) 54 that is electrically connected to the second SiC region (the emitter region) 58 and the third SiC region (the emitter contact region) 60 is formed. The first electrode (the emitter electrode) 54 is formed by Ni (nickel) and Al sputtering, for example.

In step S120, the conductive second electrode (the collector electrode) 56 is formed on the bottom surface of the p-SiC single-crystal substrate 10. The second electrode (the collector electrode) 56 is formed by Ni sputtering, for example.

In step S122, annealing is performed to lower the contact resistance between the first electrode 54 and the second electrode 56. The annealing is performed in an argon gas atmosphere at 1000°C, for example.

By the above described manufacturing method, the IGBT 100 shown in FIG. 1 is formed.

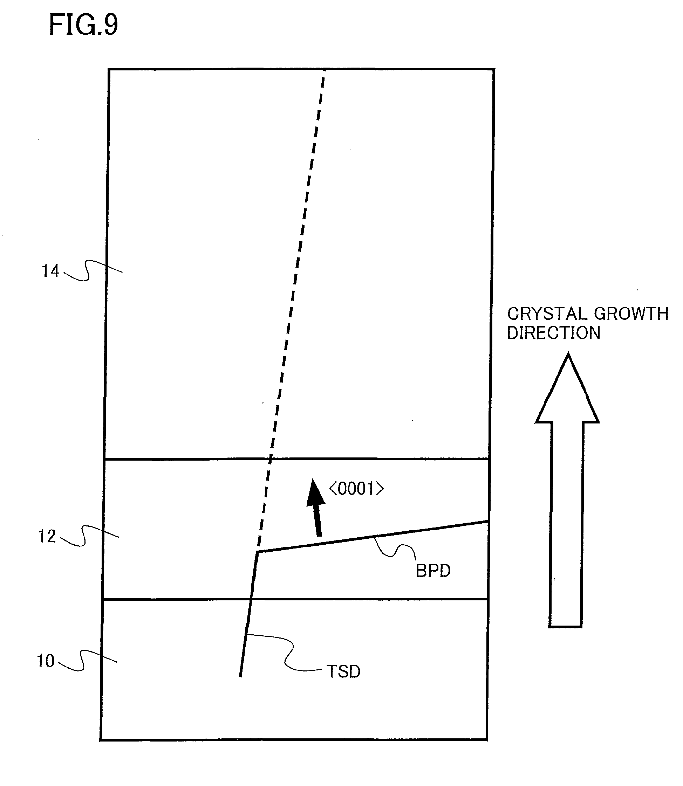

FIG. 9 is a diagram for explaining the effects of the method of manufacturing the semiconductor device of this embodiment. In this embodiment, the p-SiC single-crystal substrate 10 has an off angle that is not smaller than 0.5 degrees and not larger than 8 degrees with respect to the {0001} plane, for example.

In the p-SiC single-crystal substrate 10, threading screw dislocations (TSDs) exist in a region extending from the inside to the surface. If the p-SiC single-crystal layer 12 and the nSiC layer 14 are epitaxially grown by a vapor phase growth technique on the p-SiC single-crystal substrate 10 having TSDs in its surface, the TSDs might extend into the n⁻-SiC layer 14, and reach the surface of the n⁻-SiC layer 14, as indicated by the dashed line in FIG. 9. For example, the gate insulating film 28 is formed by thermal oxidation in the surface of the n⁻-SiC layer 14 having TSDs in the surface. In that case, the reliability of the gate insulating film 28 becomes lower due to the TSDs.

In this embodiment, the p-SiC single-crystal layer 12 is formed on the surface of the p-SiC single-crystal substrate 10 by using a liquid phase growth technique. With the liquid phase growth technique, TSDs are converted into basal plane dislocations (BPDs) in the p-SiC single-crystal layer 12. BPDs extend along the {0001} plane, and exit the p-SiC single-crystal layer 12 from a side surface. In other words, the BPDs extend in accordance with the off angle, and exit from a side surface. In this manner, the TSDs are restrained from reaching the surface of the n--SiC layer 14. Accordingly, the reliability of the gate insulating film 28 formed on the surface of the n⁻-SiC layer 14 is increased.

If BPDs exist in the n⁻-SiC layer 14, there is also a possibility that the on-state resistance increases at the time of forward-current application to the IGBT 100, and device characteristics might be degraded. According to this embodiment, BPDs exit the p-SiC single-crystal layer 12 from a side surface, and the BPDs are restrained from extending into the n⁻-SiC layer 14. Accordingly, degradation of device characteristics due to BPDs can also be prevented.

The surface of the p-SiC single-crystal substrate 10 preferably has an off angle that is not smaller than 0.5 degrees and not larger than 8 degrees, or more preferably, not smaller than 2 degrees and not larger than 6 degrees, with respect to the {0001} plane. If the off angle is below the range, stable epitaxial growth might not be achieved. If the off angle is above the range, the unevenness of the crystal surface becomes larger, and the reliability of the gate insulating film formed on the surface might become lower. If the off angle is above the range, the efficiency at which BPDs converted from TSDs are released from a crystal side surface might become lower.

In this embodiment, the p-SiC single-crystal layer 12 is co-doped with Al (aluminum) as the p-type impurity and N (nitrogen) as the n-type impurity at a predetermined ratio. With this arrangement, resistance of the p-SiC single-crystal layer 12 is lowered. Accordingly, on-state resistance of the IGBT 100 is lowered.

In this embodiment, the n-type impurity is preferably N (nitrogen) or P (phosphorus), for example, but it is possible to use As (arsenic) or the like. Also, the p-type impurity is preferably Al (aluminum), for example, but it is possible to use B (boron), Ga (gallium), In (indium), or the like.

In the following, the function and effects of the co-doping of this embodiment are described in detail.

It has become apparent from the results of studies made by the inventors that pairing between Al and N can be caused by co-doping SiC with Al as the p-type impurity (p-type dopant) and N as the n-type impurity (n-type dopant). In this pairing state, carrier compensation occurs, and a zero-carrier state is formed.

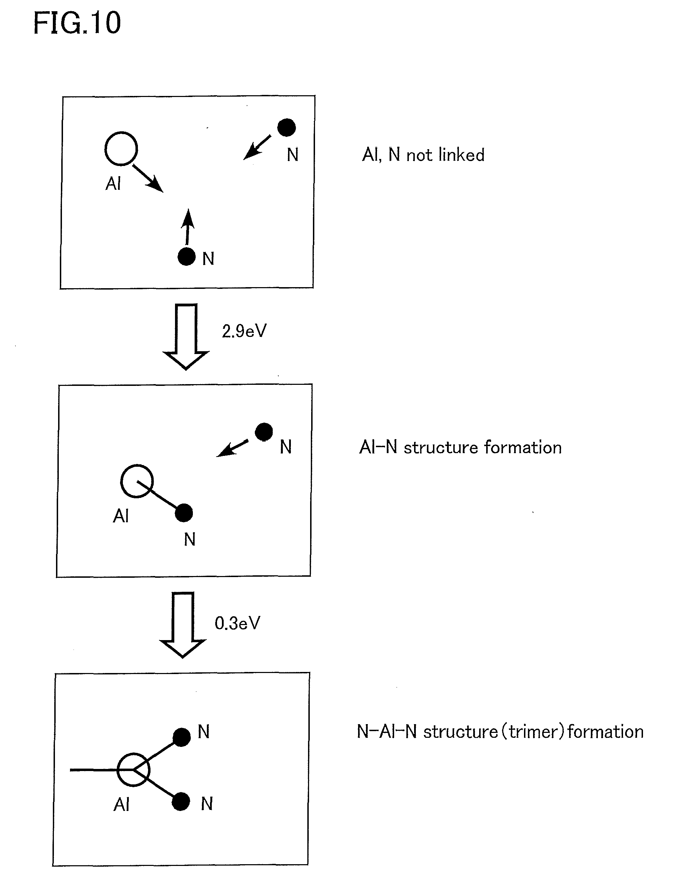

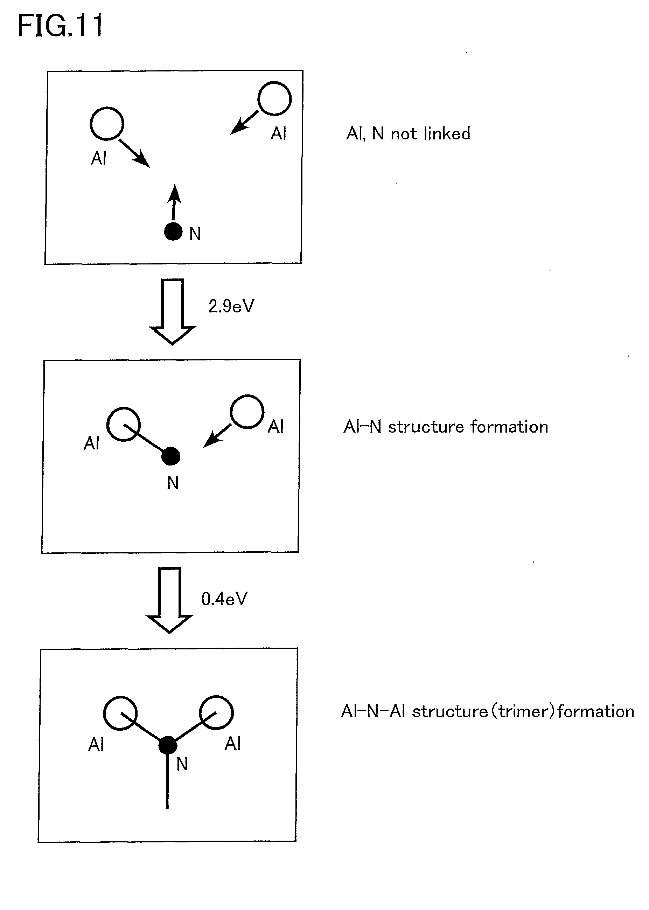

FIGS. 10 and 11 are diagrams for explaining the function of co-doping. FIG. 10 shows the case of n-type SiC, and FIG. 11 shows the case of p-type SiC. It has become apparent from the first principle calculation performed by the inventors that Al enters Si (silicon) sites and N enters C (carbon) sites in SiC so that Al and N become adjacent to each other, and, as a result, the system becomes stable.

Specifically, as shown in FIGS. 10 and 11, where Al and N are linked to each other to form Al-N pair structures, the system becomes 2.9 eV more stable in terms of energy than a system in which Al and N are not linked to each other but exist independently of each other. If the Al amount and the N amount are the same, the most stable state is achieved when all of the two elements form pair structures.

Here, the first principle calculation is a calculation using ultrasoft pseudopotential. Ultrasoft pseudopotential is a type of pseudopotential, and was developed by Vanderbilt et al. For example, a lattice constant has such a high precision as to realize experimental values with a margin of error of 1% or less. Structural relaxation is achieved by introducing impurities (dopant), and the entire energy of a stable state is calculated. The energy of the entire system after a change is compared with the energy prior to the change, so as to determine which structures are in a stable state. In a stable state, in which energy positions impurity levels are located in the band gap can be indicated.

As shown in FIG. 10, it has become apparent that, in a case where the amount of N is larger than the amount of Al, or in the case of n-type SiC, extra N enters C sites located in the vicinities of Al-N pair structures, to form N-Al-N trimers and further stabilize the system. According to the first principle calculation, trimers are formed, and the system becomes 0.3 eV more stable than a system in which pair structures exist separately from N.

Likewise, as shown in FIG. 11, it has become apparent that, in a case where the amount of Al is larger than the amount of N, or in the case of p-type SiC, extra Al enters Si sites located in the vicinities of Al-N pair structures, to form Al-N-Al trimers and further stabilize the system. According to the first principle calculation, trimers are formed, and the system becomes 0.4 eV more stable than a system in which Al-N pair structures exist separately from Al.

Next, dopant combinations other than the combination of Al and N are discussed. Calculation results obtained in a case where a calculation was conducted for a combination of B (boron) and N (nitrogen) are described below.

B enters Si sites, and N enters C sites. According to the first principle calculation, B-N-B or N-B-N trimeric structures cannot be formed. Specifically, B-N pair structures are formed, but the energy of the system becomes higher when B or N approaches the B-N pair structures. Accordingly, the system is more stable in terms of energy when extra B or N exists in positions sufficiently away from the pair structures.

According to the first principle calculation, when extra B forms trimers, the energy of the system is 0.5 eV higher than that in a case where B-N pairs exist independently of B. Also, when extra N forms trimers, the energy of the system is 0.3 eV higher than that in a case where B-N pairs exist independently of N. Therefore, in either case, the system becomes unstable in terms of energy when trimers are formed.

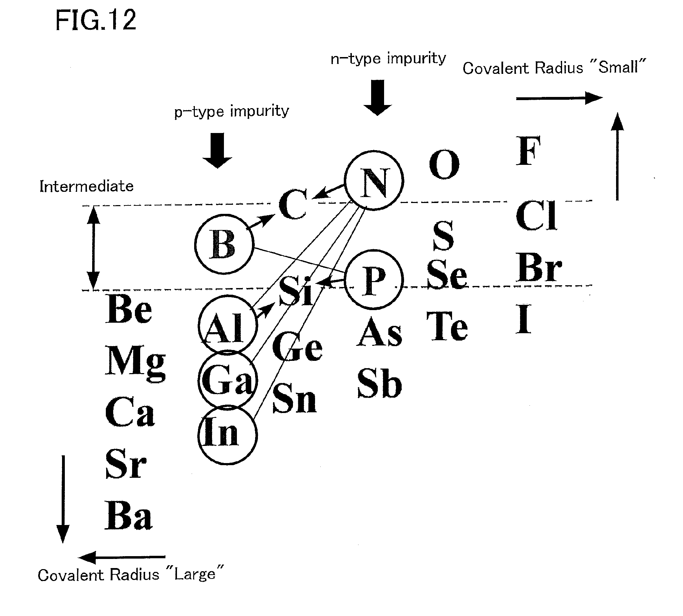

FIG. 12 is a diagram for explaining the function of co-doping. FIG. 12 shows the covalent radii of respective elements. Elements with smaller covalent radii are shown in the upper right portion in the drawing, and elements with larger covalent radii are shown in the lower left portion.

Considering the covalent radii, it is understandable that the system becomes unstable when trimers are formed with B and N. The covalent radius of B is smaller than the covalent radius of Si, and the covalent radius of N is smaller than the covalent radius of C. Therefore, when B enters Si sites and N enters C sites, strain accumulates, and trimers cannot be formed.

It has become apparent that trimers are not formed with combinations of the p-type impurity and the n-type impurity as dopant other than the combinations of "an element (Al, Ga, or In) having a larger covalent radius than Si" and "an element (N) having a smaller covalent radius than C", and the reverse combination of "an element (B) having a larger covalent radius than C" and "an element (P) having a smaller covalent radius than Si".

Since the covalent radii of B and P are between the covalent radius of Si and the covalent radius of C, B and P can enter both Si sites and C sites. However, the other impurities (Al, Ga, In, N, and As) basically enter either Si sites or C sites. It is safe to say that Al, Ga, In, and As enter Si sites, and N enters C sites.

Furthermore, when both impurities enter Si sites or both impurities enter C sites, there is no need to take into account such an aspect. This is because it is difficult to relax strain unless the p-type impurity and the n-type impurity are located at the closest distance from each other. Therefore, where the p-type impurity is the element A and the n-type impurity is the element D, it is difficult to form trimers with combinations of the element A and the element D other than the four combinations of "Al and N", "Ga and N", "In and N", and "B and P".

The pair structures or the trimeric structures cannot be formed unless there is interaction between atoms. If approximately 10 unit cells exist in the c-axis direction, the interaction is invisible, and the impurity levels (dopant levels) in a 4H-SiC structure according to the first principle calculation are in a flat state. That is, diffusion is sufficiently restrained, and is on the order of approximately 10 meV.

In other words, it is considered that there is little interaction when the distance between impurities is 10 nm or longer. In view of this, to maintain interaction between impurities, the impurity densities are preferably 1 × 10¹⁸ cm⁻³ or higher.

This value is the lower limit of impurity densities that is desired when a local impurity distribution is formed through ion implantation in a case where a SiC material has already been formed. With a liquid phase growth technique or a vapor phase growth technique, the lower limit of impurity densities becomes even lower.

To cause an effect of co-doping to appear in semiconductor SiC, the ratio between the n-type impurity concentration and the p-type impurity concentration needs to be restricted within a specific range. By the later described manufacturing method, it is critical that the ratio between the n-type and p-type impurities to be introduced by ion implantation be set at a ratio within the specific range from the start. Although the reach of interaction is as short as less than 10 nm, trimers can be formed by virtue of the attraction force of each other within the reach. Furthermore, as the attraction force is applied, the temperature of the activating anneal for the impurities can be lowered from 1700-1900°C, which is the temperature range in a case where co-doping is not performed, to 1500-1800°C.

However, the impurity concentration desirable for trimer formation can be lowered in crystal growth from a vapor phase by CVD (Chemical Vapor Deposition) or the like. This is because precursor gases can be made to flow in the surface, and accordingly, interaction between the impurities can easily occur at low densities.

When trimers are to be formed at the time of crystal growth from a vapor phase, the densities of the p-type and n-type impurities are preferably 1 × 10¹⁵ cm⁻³ or higher. Further, so as to facilitate the trimer formation, the impurity densities are preferably 1 × 10¹⁶ cm⁻³ or higher.

When trimers are formed, the upper limit of impurity densities may exceed the solid solubility limit of cases where trimers are not formed. This is because, when trimers are formed, strain in crystals is relaxed, and the impurities are easily incorporated.

The impurity solid solubility limit in a case where trimers are not formed is on the order of 10¹⁹ cm⁻³ in the case of N, and is on the order of 10²¹ cm⁻³ even in the case of Al. As for the other impurities, the solid solubility limit is on the order of approximately 10²¹ cm⁻³.

When only one type of impurity is used, the size of the impurity is either small or large. Therefore, strain accumulates, and the impurity cannot easily enter lattice points. As a result, activation cannot be caused. Particularly, in the case of ion implantation, a large number of defects are formed, and the solid solubility limit becomes even lower.

However, when trimers are formed, both Al and N can be implanted up to the order of approximately 10²² cm⁻³. As strain can be relaxed by forming trimers with one of the four combinations of "Al and N", "Ga and N", "In and N", and "B and P", the solid solubility limit can be extended. As a result, the impurity solid solubility limit can be extended to the order of 10²² cm⁻³.

In a case where the impurity is B, Al, Ga, In, or P, strain is large, and a large number of defects exist, if the impurity concentration is 1 × 10²⁰ cm⁻³ or higher, or more particularly, 6 × 10²⁰ cm⁻³ or higher. As a result, sheet resistance or resistivity becomes very high.

However, co-doping with the p-type impurity and the n-type impurity can reduce defects even in regions having such high impurity densities.

When an impurity is N, the solid solubility limit is further lowered by one digit to approximately 2 × 10¹⁹ cm⁻³. According to the first principle calculation, this is probably because defects of inactive interstitial N are formed.

As trimers are formed, the upper limit of the N concentration is dramatically increased from the order of 10¹⁹ cm⁻³ to the order of 10²² cm⁻³. In a case where an n-type region doped at a high concentration is to be formed, nitrogen cannot be normally used, and P ions are implanted at approximately 10²⁰ cm⁻³, for example. In this embodiment, however, an n-type region doped at a high concentration can be formed by using nitrogen. For example, N is implanted at 2 × 10²⁰ cm⁻³, and Al is implanted at 1 × 10²⁰ cm⁻³. It is normally difficult to use nitrogen, but nitrogen can be used in this embodiment.

As described above, both the p-type impurity and the n-type impurity are implanted, and an appropriate combination of covalent radii is selected, so that trimers can be formed. The structures are then stabilized, and strain can be reduced.

As a result, (1) the respective impurities can easily enter lattice points, (2) the process temperature can be lowered, and a temperature decrease of at least 100°C can be expected, (3) the amount of impurities that can be activated increases (the upper limit is extended), (4) stable structures such as trimers or pair structures can be formed, and entropy is increased and crystal defects are reduced with the structures, and (5) as the trimers are stable, revolutions around the bonds that bind the p-type impurity and the n-type impurity become difficult, and the structures are immobilized. Accordingly, energization breakdown tolerance becomes dramatically higher. For example, when trimeric structures are formed in at least part of the p-type impurity region and the n-type impurity region of a pn junction, energization breakdown is restrained, and an increase in resistance can be avoided. As a result, a degradation phenomenon (Vf degradation) in which the voltage (Vf) required to be applied so as to apply a certain amount of current becomes higher can be restrained.

As described above, pairing between Al and N can be caused by co-doping with Al as the p-type impurity and N as the n-type impurity. Furthermore, it has become apparent from the first principle calculation that both acceptor levels and donor levels can be made shallower at this point.

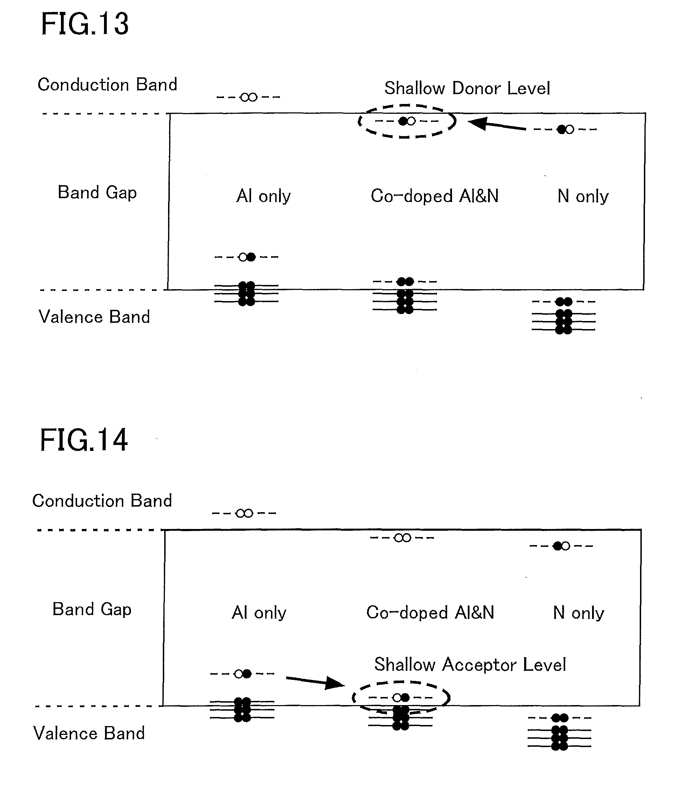

FIGS. 13 and 14 are diagrams for explaining the function of co-doping. FIG. 13 shows the case of n-type SiC, and FIG. 14 shows the case of p-type SiC. White circles represent empty levels not filled with electrons, and black circles represent levels filled with electrons.

The reason that the donor levels become shallower is that the empty levels located within the conduction band of Al as the acceptor interact with the donor levels of N, and the donor levels are raised, as shown in FIG. 13. Likewise, the reason that the acceptor levels become shallower is that the levels that are filled with electrons and are located within the valence band of N as the donor interact with the acceptor levels of Al, and the acceptor levels are lowered, as shown in FIG. 14.

Normally, N or P (phosphorus) as the n-type impurity forms donor levels that are as deep as 42 to 95 meV. B, Al, Ga, or In as the p-type impurity forms very deep acceptor levels of 160 to 300 meV. If trimers are formed, on the other hand, the n-type impurity can form donor levels of 35 meV or lower, and the p-type impurity can form acceptor levels of 100 meV or shallower.

In an optimum state where trimers are completely formed, n-type N or P forms levels of approximately 20 meV, and p-type B, Al, Ga, or In forms levels of approximately 40 meV. As such shallow levels are formed, most of the activated impurities turn into carriers (free electrons and free holes). Accordingly, the bulk resistance becomes one or more digits lower than that in a case where co-doping is not performed.

In the case of n-type SiC, the donor levels that contribute to carrier generation becomes 40 meV or shallower, and as a result, the resistance becomes lower than that in a case where co-doping is not performed. Also, as the donor levels become 35 meV or shallower, the resistance is lowered by approximately one digit. As the donor levels become 20 meV or shallower, the resistance is lowered by approximately two digits. However, a strain relaxation effect and a doping upper limit extension effect are also achieved.

In the case of p-type SiC, the acceptor levels that contribute to carrier generation become 150 meV or shallower, and as a result, the resistance becomes lower than that in a case where co-doping is not performed. Also, as the acceptor levels become 100 meV or shallower, the resistance is lowered by approximately one digit. As the acceptor levels become 40 meV or shallower, the resistance is lowered by approximately two digits. However, a strain relaxation effect and a doping upper limit extension effect are also achieved.

When the Al concentration and the N concentration are the same (N : Al = 1 : 1), an insulator is formed, because there are no carriers though there are shallow levels. There exist carriers that are equivalent to a difference between the Al concentration and the N concentration. To form a low-resistance semiconductor, a concentration difference is required.

When the N concentration is higher than the Al concentration (N concentration > Al concentration), extra N generated as a result of formation of Al-N pairs through interaction is also stabilized by substituting C located in the vicinities of the Al-N pairs. Accordingly, shallow donor levels are formed. Also, strain is relaxed. Accordingly, the N concentration can be made higher than that in a case where trimers are not formed.

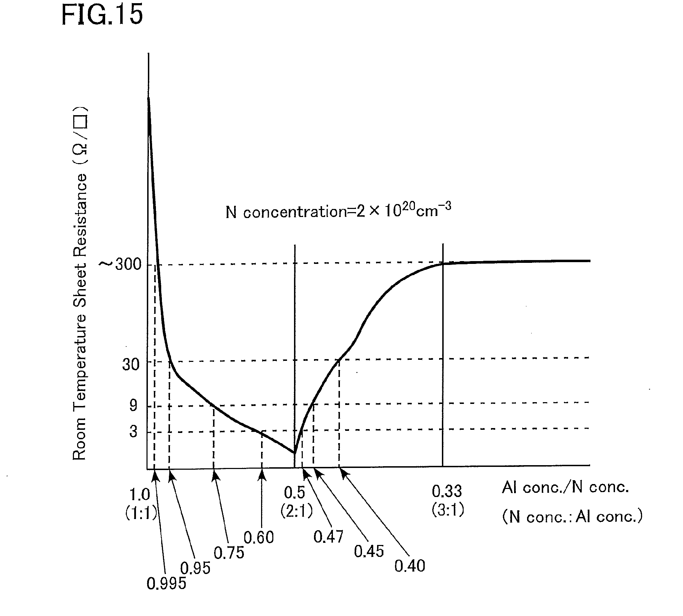

FIG. 15 is a diagram showing the relationship between Al and N densities and sheet resistance in the case of n-type SiC. The N concentration is 2 × 10²⁰ cm⁻³. When only N is implanted, the sheet resistance cannot be lowered even if N is implanted at 1 × 10¹⁹ cm⁻³ or higher. The value is approximately 300 Ω/□.

While "N concentration : Al concentration" is changing from 1 : 1 to 2 : 1, trimers are formed without strain, and the number of carrier electrons in the shallow donor levels increases. Accordingly, the sheet resistance rapidly decreases.

When the ratio reaches 2 : 1, the maximum amount of carriers is available, and the sheet resistance becomes lowest. As shown in FIG. 15, the sheet resistance can be lowered down to approximately 1.5 Ω/□. The contact resistance to n-type SiC can also be lowered from approximately 10⁻⁵ Ωcm³ to approximately 10⁻⁷ Ωcm³ by making "N concentration : Al concentration" equal to 2 : 1 and increasing the difference between the N concentration and the Al concentration from 10²⁰ cm⁻³ to 10²² cm⁻³.

Furthermore, if the ratio of the N concentration becomes higher than 2 : 1, the original deep donor levels are formed by the extra N that exceeds "N concentration : Al concentration = 2 : 1". The donor levels receive carrier electrons, and the shallow donor levels formed with trimers become empty. The excess N left out from "N concentration : Al concentration = 2 : 1" is similar to N introduced independently. Therefore, strain relaxation is difficult. As a result, the sheet resistance rapidly increases as shown in FIG. 15.

In FIG. 15, the target for comparison is the sheet resistance (approximately 300 Ω/□ in this case) in a case where N (nitrogen) as the n-type impurity is implanted almost up to the solid solubility limit when co-doping with Al is not performed, and changes in the sheet resistance value seen when "N concentration : Al concentration" is changed from 2 : 1 are shown.

The following description centers around "Al concentration/N concentration = 0.5", at which trimer structures are formed. In a case where "Al concentration/N concentration" is not lower than 0.47 and not higher than 0.60 (100% of the carriers of 8 × 10¹⁹ cm⁻³ or higher being free carriers), or where the p-type impurity is implanted at 47 to 60% with respect to the n-type impurity, the sheet resistance is two digits lower than the sheet resistance obtained in a case where co-doping with Al is not performed. Such a concentration ratio is highly advantageous. When the ratio is lower than 0.5, shallow levels decrease, and strain is caused. As a result, the number of free carriers decreases, and carriers equivalent to 8 × 10¹⁹ cm⁻³ are obtained when the ratio is approximately 0.47.

In a case where the range is widened in both directions, and "Al concentration/N concentration" is not lower than 0.45 and not higher than 0.75 (100% of the carriers of 5 × 10¹⁹ cm⁻³ or higher being free carriers), or where Al is implanted at 45 to 75% with respect to N, the sheet resistance ranges from a two-digit-lower resistance to a resistance almost three times higher than the two-digit-lower resistance. When the ratio is lower than 0.5, shallow levels decrease, and strain is caused. As a result, the number of free carriers decreases, and carriers equivalent to 5 × 10¹⁹ cm⁻³ are obtained when the ratio is approximately 0.45. In a case where the range is further widened in both directions and "Al concentration/N concentration" is higher than 0.40 but lower than 0.95 (100% of the carriers of 1 × 10¹⁹ cm⁻³ or higher being free carriers), or where Al is implanted at 40 to 95% with respect to N, the sheet resistance becomes one digit lower. When the ratio is lower than 0.5, shallow levels decrease, and strain is caused. As a result, the number of free carriers decreases, and carriers equivalent to 1 × 10¹⁹ cm⁻³ are obtained when the ratio is approximately 0.40.

Better characteristics are achieved on the side where Al is implanted at 50% or more with respect to N, because strain is sufficiently relaxed. The 50% state is the state where two N atoms and one Al atom are clustered to form a trimer. When the ratio is lower than 50%, trimers are formed, and extra N exists. Since there is N that cannot form trimers, an equivalent amount of strain accumulates. N that cannot form trimers is the same as that introduced independently, and reaches the limit of strain in no time. When the amount of Al is lower than 50%, strain rapidly occurs, and lattice defects increase. Therefore, the sheet resistance rapidly deteriorates when the ratio is lower than 50%, compared with that in a case where the ratio is 50% or higher at which strain can be relaxed.

When "Al concentration/N concentration" is 0.995, the number of carriers is almost the same as that in a case where co-doping is not performed. Since 100% of the carriers of 1 × 10¹⁸ cm⁻³ or higher, which is 0.5% of 2 × 10²⁰ cm⁻³, are free carriers, the sheet resistance to be obtained with conventional nitrogen doping can be realized. Accordingly, the sheet resistance is almost the same as that in a case where co-doping is not performed. In a case where "Al concentration/N concentration" is 0.33 or where "N concentration : Al concentration" is 3 : 1, all carrier electrons are received not by shallow donor levels formed with trimers but by deep donor levels formed with extra N. Accordingly, the sheet resistance is almost the same as that in a case where co-doping is not performed. Therefore, the resistance is lowered by co-doping in cases where "Al concentration/N concentration" is higher than 0.33 but lower than 0.995, or where Al is implanted at 33 to 99.5% with respect to N. With the margin of error being taken into account, it can be considered that the ratio of Al to N should be higher than 33% but lower than 100%.

When the Al concentration is higher than the N concentration (Al concentration > N concentration), extra Al generated as a result of formation of Al-N pairs through interaction is also stabilized by substituting Si located in the vicinities of the Al-N pairs. Accordingly, shallow acceptor levels are formed. Also, strain is relaxed. Accordingly, the Al concentration can be made higher than that in a case where trimers are not formed. This case can be considered to be the same as the case where the N concentration is higher than the Al concentration.

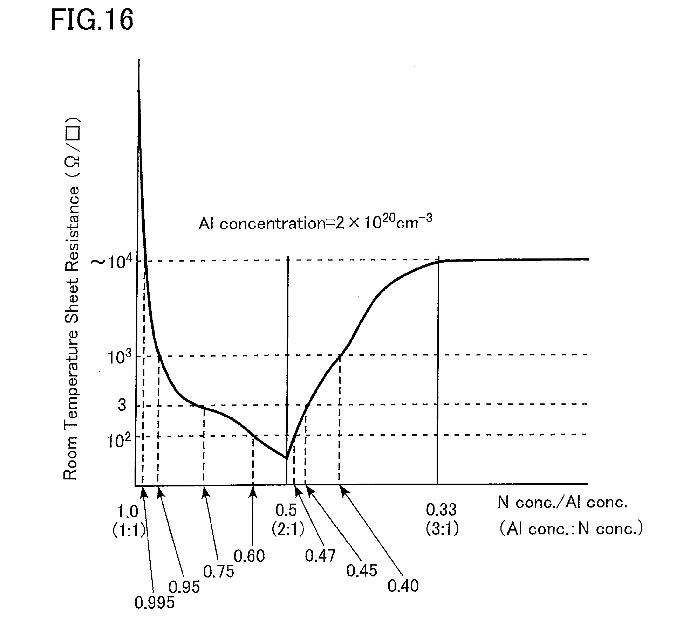

FIG. 16 is a diagram showing the relationship between N and Al densities and sheet resistance in the case of p-type SiC. The Al concentration is 2 × 10²⁰ cm⁻³.

While "Al concentration : N concentration" is changing from 1 : 1 to 2 : 1, trimers are formed without strain, and the number of carrier holes in the shallow acceptor levels increases. Accordingly, the sheet resistance decreases.

When the ratio reaches 2 : 1, the maximum amount of carriers is available, and the sheet resistance becomes lowest. As shown in FIG. 16, the sheet resistance can be lowered down to approximately 40 Ω/□. The contact resistance to p-type SiC can also be lowered from approximately 10⁻⁵ Ωcm³ to approximately 10⁻⁷ Ωcm³ by making "Al concentration : N concentration" equal to 2 : 1 and increasing the difference between the Al concentration and the N concentration from 10²⁰ cm⁻³ to 10²² cm⁻³.

Furthermore, if the ratio of the Al concentration becomes higher than 2 : 1, the original deep acceptor levels are formed by the extra Al that exceeds "Al concentration : N concentration = 2 : 1 ". The acceptor levels receive carrier holes, and the shallow acceptor levels formed with trimers are filled with electrons. The excess Al left out from "Al concentration : N concentration = 2 : 1" is similar to N introduced independently. Therefore, strain relaxation is difficult. As a result, the sheet resistance rapidly increases as shown in FIG. 16.

In FIG. 16, the target for comparison is the sheet resistance (approximately 10 kΩ/□ in this case) in a case where Al (aluminum) as the p-type impurity is implanted almost up to the solid solubility limit when co-doping with N is not performed, and changes in the sheet resistance value seen when "Al concentration : N concentration" is changed from 2 : 1 are shown.

The following description centers around "N concentration/Al concentration = 0.5", at which trimer structures are formed. In a case where "N concentration/Al concentration" is not lower than 0.47 and not higher than 0.60 (100% of the carriers of 8 × 10¹⁹ cm⁻³ or higher being free carriers), or where the n-type impurity is implanted at 47 to 60% with respect to the p-type impurity, the sheet resistance is two digits lower than the sheet resistance obtained in a case where co-doping with N is not performed. Such a concentration ratio is highly advantageous. When the ratio is lower than 0.5, shallow levels decrease, and strain is caused. As a result, the number of free carriers decreases, and carriers equivalent to 8 × 10¹⁹ cm⁻³ are obtained when the ratio is approximately 0.47.

In a case where the range is widened in both directions, and "N concentration/Al concentration" is not lower than 0.45 and not higher than 0.75 (100% of the carriers of 5 × 10¹⁹ cm⁻³ or higher being free carriers), or where N is implanted at 45 to 75% with respect to Al, the sheet resistance ranges from a two-digit-lower resistance to a resistance almost three times higher than the two-digit-lower resistance. When the ratio is lower than 0.5, shallow levels decrease, and strain is caused. As a result, the number of free carriers decreases, and carriers equivalent to 5 × 10¹⁹ cm⁻³ are obtained when the ratio is approximately 0.45. In a case where the range is further widened in both directions and "N concentration/Al concentration" is higher than 0.40 but lower than 0.95 (100% of the carriers of 1 × 10¹⁹ cm⁻³ or higher being free carriers), or where N is implanted at 40 to 95% with respect to Al, the sheet resistance becomes one digit lower. When the ratio is lower than 0.5, shallow levels decrease, and strain is caused. As a result, the number of free carriers decreases, and carriers equivalent to 1 × 10¹⁹ cm⁻³ are obtained when the ratio is approximately 0.40.

Better characteristics are achieved in cases where N is implanted at 50% or more with respect to Al, because strain is relaxed. When N is less than 50%, on the other hand, trimers formed with one N atom and two Al atoms that are clustered account for 50% of the entire structure, and further, Al exists therein. Since there is Al that cannot form trimers, an equivalent amount of strain accumulates. When the amount of N is lower than 50%, strain rapidly occurs, and lattice defects increase. Therefore, the sheet resistance rapidly deteriorates when the ratio is lower than 50%, compared with that in a case where the ratio is 50% or higher at which strain can be relaxed.

At this point, "N concentration/Al concentration" is 0.995, and the number of carriers is almost the same as that in a case where co-doping is not performed. Since 100% of the carriers of 1 × 10¹⁸ cm⁻³ or higher, which is 0.5% of 2 × 10²⁰ cm⁻³, are free carriers, the sheet resistance to be achieved with conventional Al doping can be realized. Accordingly, the sheet resistance is almost the same as that in a case where co-doping is not performed. In a case where "N concentration/Al concentration" is 0.33 or where "Al concentration : N concentration" is 3 : 1, all carrier holes are received not by shallow acceptor levels formed with trimers but by deep acceptor levels formed with extra Al. Accordingly, the sheet resistance is almost the same as that in a case where co-doping is not performed. Therefore, a resistance lowering effect is achieved by co-doping in cases where "N concentration/Al concentration" is higher than 0.33 but lower than 0.995, or where N is implanted at 33 to 99.5% with respect to Al. With the margin of error being taken into account, it can be considered that the ratio of Al to N should be higher than 33% but lower than 100%.

When co-doping is not performed, a low-resistance SiC semiconductor material containing impurities having low densities of 1 × 10¹⁸ cm⁻³ or lower cannot exist. However, when trimers are formed by co-doping, shallow levels are formed, and the number of carriers increases. Accordingly, a reduction in resistance can be achieved with small amounts of impurities.

Co-doping with the p-type impurity and the n-type impurity at an appropriate ratio as described above can achieve at least two notable effects.

First, strain is relaxed, and SiC with less strain can be formed. Compared with a case where co-doping is not performed, strain is smaller, the number of defects is smaller, and larger amounts of impurities can be implanted. That is, the solid solubility limits of impurities can be raised. Accordingly, the sheet resistance, the resistivity, and the contact resistance are lowered. As fewer defects are formed by either ion implantation or epitaxial growth, dosing of large amounts of impurities can be performed.

Secondly, shallow levels can be formed. Compared with a case where co-doping is not performed, a low-resistance material can be formed with smaller amounts of impurities. Alternatively, a sheet resistance that is one or more digits lower can be achieved with the same amounts of impurities as those in a case where co-doping is not performed. In a region that can be formed through epitaxial growth and contains a low-dose impurity, the resistance becomes higher unless co-doping is performed. However, low-resistance SiC can be formed when co-doping is performed. Accordingly, a SiC semiconductor device having a lower on-state resistance can be manufactured.

In the IGBT 100 of this embodiment, the p-type SiC single-crystal layer 12 is co-doped with a p-type impurity such as Al and an n-type impurity such as N. With this arrangement, the sheet resistance and the resistivity of the p-type SiC single-crystal layer 12 are lowered. Accordingly, a reduction in on-state resistance is achieved, and the high-performance IGBT 100 is realized.

As trimers are formed, the crystalline structures are stabilized, and crystal defects are reduced. Accordingly, the IGBT 100 having smaller leakage current is realized. Furthermore, as the crystalline structures are stabilized, the IGBT 100 that has excellent energization breakdown tolerance is realized. That is, the IGBT 100 is highly reliable against deterioration due to energization.

As for deterioration due to energization, there is a mode in which crystal defects having 3C structures are formed, and the resistance becomes higher. With the co-doped structure of this embodiment, the crystals are stable, and such a mode does not appear. Accordingly, the IGBT 100 that does not cause the resistance increasing mode to appear can be formed.

The concentration of the p-type impurity contained in the p-SiC single-crystal layer 12 is preferably not lower than 1 × 10¹⁸ cm⁻³ and not higher than 1 × 10²² cm⁻³. This is also because, if the concentration is below the range, there is a possibility that interaction between the p-type impurity and the n-type impurity does not easily occur, and trimers are not formed. This is also because it is difficult to incorporate the p-type impurity having a concentration higher than the range.

So as to sufficiently lower sheet resistance or resistivity of the p-SiC single-crystal layer 12, the concentration of the p-type impurity contained in the p-SiC single-crystal layer 12 is preferably 1 × 10²⁰ cm⁻³ or higher.

In a case where the p-type impurity is the element A and the n-type impurity is the element D in the p-SiC single-crystal layer 12, the ratio of the concentration of the element D to the concentration of the element A is higher than 0.33 but lower than 1.0, so as to sufficiently lower the sheet resistance or the resistivity of the third SiC region 20. Also, the ratio of the concentration of the element D to the concentration of the element A is preferably higher than 0.40 but lower than 0.95. More preferably, the ratio is not lower than 0.45 and not higher than 0.75. Even more preferably, the ratio is not lower than 0.47 and not higher than 0.60.

Therefore, the ratio of the concentration of the element D to the concentration of the element A in the liquid phase when the p-SiC single-crystal layer 12 is grown is higher than 0.33 but lower than 1.0. Also, the ratio of the concentration of the element D to the concentration of the element A is preferably higher than 0.40 but lower than 0.95. More preferably, the ratio is not lower than 0.45 and not higher than 0.75. Even more preferably, the ratio is not lower than 0.47 and not higher than 0.60.

The ratio of the concentration of the element D to the concentration of the element A in the p-SiC single-crystal layer 12 can be calculated by determining the respective densities of the element A and the element D by SIMS (Secondary Ion Microprobe Spectrometry), for example.

In a case where the p-type impurity is the element A and the n-type impurity is the element D in the p-SiC single-crystal layer 12, the acceptor levels that contribute to generation of carriers of the element A are preferably 150 meV or shallower, so as to lower sheet resistance or resistivity. More preferably, the acceptor levels are 100 meV or shallower. Even more preferably, the acceptor levels are 40 meV or shallower.

The acceptor levels of the element A can be determined by measuring the activation energy of the sheet resistance or the resistivity of the p-SiC single-crystal layer 12, for example.

So as to sufficiently lower the sheet resistance or the resistivity of the p-SiC singlecrystal layer 12, most of the p-type impurity and the n-type impurity preferably forms trimers. Therefore, 90% or more of the element D is preferably in the lattice site locations nearest to the element A. If 90% or more of the element D is in the lattice site locations nearest to the element A, most of the p-type impurity and the n-type impurity (90% or more of the part that can form trimers) can be considered to form trimers.

The proportion of the element D in the lattice site locations nearest to the element A can be determined by analyzing the binding state between the element A and the element D by XPS (X-ray Photoelectron Spectroscopy), for example.

When the p-SiC single-crystal layer 12 is grown by a liquid phase growth technique, the p-type impurity and the n-type impurity coexist at the above described predetermined ratio in the liquid phase. Therefore, conversion of TSDs into BPDs during crystal growth is facilitated. Accordingly, TSDs can be prevented from extending into an upper layer from a layer with a smaller thickness than in a case where the p-SiC single-crystal layer 12 is formed by a vapor phase growth technique, for example. Also, with the same thickness, the density of TSDs that reach the surface can be reduced.

As described above, according to the method of manufacturing the semiconductor device of this embodiment, the p-SiC single-crystal layer 12 is formed by a liquid phase growth technique. Accordingly, dislocations in a semiconductor layer surface and in a semiconductor layer of the device can be reduced, and a highly-reliable IGBT can be realized. Also, the p-SiC single-crystal layer 12 is co-doped with the p-type impurity and the n-type impurity at a predetermined ratio, so that on-state resistance is lowered, and a high-performance IGBT is realized.

Furthermore, the p-SiC single-crystal layer 12 is formed from a liquid phase co-doped with the p-type impurity and the n-type impurity at a predetermined ratio, so that conversion of TSDs into BPDs can be facilitated. Accordingly, the thickness of the p-SiC single-crystal layer 12 formed by liquid phase growth can be reduced, and productivity is increased. Also, conversion of TSDs into BPDs is facilitated, so that the density of dislocations that reach the surface can be lowered.

### (Second Embodiment)

A method of manufacturing a semiconductor device of this embodiment includes: preparing a substrate; and growing a p-type SiC single-crystal layer on the surface of the substrate from a liquid phase that contains Si (silicon), C (carbon), a p-type impurity, and an n-type impurity, the p-type impurity being an element A, the n-type impurity being an element D, the element A and the element D forming a first combination that is at least one combination selected from Al (aluminum) and N (nitrogen), Ga (gallium) and N (nitrogen), and In (indium) and N (nitrogen), and/or a second combination of B (boron) and P (phosphorus), the ratio of the concentration of the element D to the concentration of the element A in the first or second combination being higher than 0.33 but lower than 1.0, the concentration of the element A in the combination being not lower than 1 × 10¹⁶ cm⁻³ and not higher than 1 × 10²² cm⁻³.

More particularly, the substrate includes an n-type SiC layer. A SiC single-crystal layer is formed on the surface of the n-type SiC layer. An n-type second SiC region is formed in the surface of the SiC single-crystal layer. A p-type third SiC region is formed in the surface of the SiC single-crystal layer. An n-type fourth SiC region is formed in the surface of the SiC singlecrystal layer, the SiC single-crystal layer being interposed between the second SiC region and the fourth SiC region. Agate insulating film is formed on the surfaces of the fourth SiC region and the SiC single-crystal layer. Agate electrode is formed on the gate insulating film. A first electrode connected to the second SiC region and the third SiC region is formed. A second electrode connected to the SiC layer is formed.

Explanation of the same aspects as those of the function and effects of the liquid phase growth technique and the co-doping of the first embodiment will not be repeated. Also, explanation of the same aspects as those of the semiconductor device and the method of manufacturing the semiconductor device of the first embodiment will not be repeated.

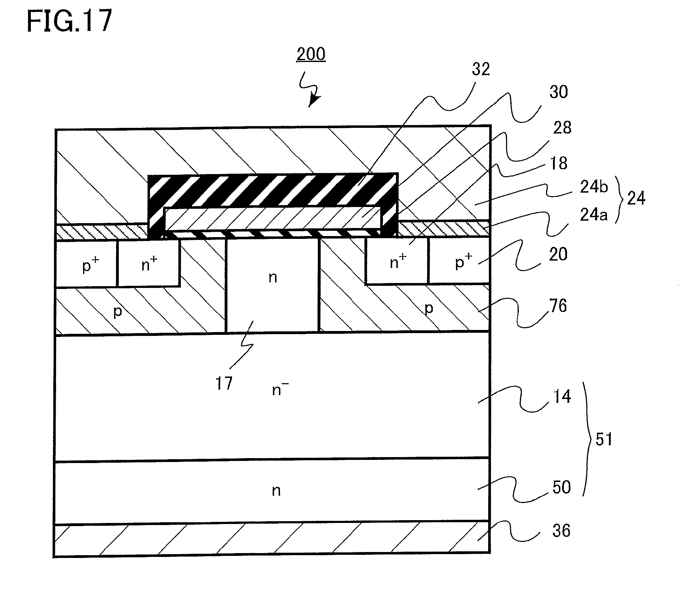

FIG. 17 is a schematic cross-sectional view of the structure of a MOSFET (Metal Oxide Semiconductor Field Effect Transistor) that is a semiconductor device of this embodiment. The MOSFET 200 is an n-type vertical MOSFET that has electrons as carriers.

The MOSFET 200 includes a substrate 51. The substrate 51 includes an n-type SiC substrate (an n-SiC single-crystal substrate) 50 and an n-type SiC layer (an n⁻-SiC layer) 14 on the surface of the n-SiC single-crystal substrate 50.

The n-SiC single-crystal substrate 50 is a 4H-SiC substrate (an n-substrate) containing N (nitrogen) as the n-type impurity, for example, at an impurity concentration that is not lower than 1 × 10¹⁸ cm⁻³ and not higher than 1 × 10¹⁹ cm⁻³, for example.

The concentration of the n-type impurity in the n-type SiC layer (the n⁻-SiC layer) 14 is not lower than 5 × 10¹⁵ cm⁻³ and not higher than 2 × 10¹⁶ cm⁻³, for example. The thickness of the n⁻-SiC layer 14 is not smaller than 5 µm and not greater than 20 µm, for example.

A p-type SiC single-crystal layer (a p-SiC single-crystal layer: a p-well region) 76 formed by a liquid phase growth technique is provided on the surface of the n⁻-SiC layer 14. This p-type SiC single-crystal layer 76 is co-doped with the p-type impurity and the n-type impurity. Where the p-type impurity is an element A and the n-type impurity is an element D, the element A and the element D form a first combination that is at least one combination selected from Al (aluminum) and N (nitrogen), Ga (gallium) and N (nitrogen), and In (indium) and N (nitrogen), and/or a second combination of B (boron) and P (phosphorus). The ratio of the concentration of the element D to the concentration of the element A in the first or second combination (concentration D/concentration A) is higher than 0.33 but lower than 1.0. In this embodiment, the impurity concentration of the element A is not lower than 1 × 10¹⁶ cm⁻³ and not higher than 5 × 10¹⁷ cm⁻³.

In the case of the first combination of Al (aluminum), Ga (gallium), or In (indium) and N (nitrogen), for example, the element A may be a single element selected from Al (aluminum), Ga (gallium), and In (indium). Alternatively, the element A may be formed with two elements such as Al (an element A₁) and Ga (an element A₂) or may be formed with three elements such as Al (the element A₁), Ga (the element A₂), and In (an element A₃). In a case where the element A is formed with more than one element, the element A may be formed with two or three kinds of elements, as long as the above described conditions on the ratio of the concentration of the element D to the concentration of the element A and on the concentration of the element A are satisfied.

The first combination and the second combination can coexist. However, the above described conditions on the ratio of the concentration of the element D to the concentration of the element A and on the concentration of the element A should be satisfied with elements that form at least one of the first and second combinations. In other words, each of the first combination and the second combination should satisfy the conditions on the element ratio and the element concentration. This is because the later described trimers are not formed between an impurity in the first combination and an impurity in the second combination.

In a case where the Al concentration is 1 × 10¹⁷ cm⁻³, the Ga concentration is 1 × 10¹⁷ cm⁻³, and the N concentration is 1 × 10¹⁷ cm⁻³, for example, N/(Al + Ga) is 0.5, and (Al + Ga) is 2 × 10¹⁷ cm⁻³. In this case, the element ratio and the element concentrations are within the ranges set by this embodiment.

In a case where the B concentration is 4 × 10¹⁷ cm⁻³, the P concentration is 1 × 10¹⁷ cm⁻³, and the N concentration is 1 × 10¹⁷ cm⁻³, for example, attention is paid only to B and P, which forms the second combination. As a result, P/B is 0.25, which does not satisfy the element ratio condition, and the element ratio is outside the range set by this embodiment.

Also, in a case where the Al concentration is 5 × 10¹⁵ cm⁻³, the B concentration is 5 × 10¹⁵ cm⁻³, the N concentration is 2.5 × 10¹⁵ cm⁻³, and the P concentration is 2.5 × 10¹⁵ cm⁻³, N/Al is 0.5, which satisfies the ratio condition, but the Al concentration is lower than 1 × 10¹⁶ cm⁻³ in the first combination. In the second combination, P/B is 0.5, which satisfies the ratio condition, but the B concentration is lower than 1 × 10¹⁶ cm⁻³. Therefore, either of the first and second combinations does not satisfy the desirable element concentration condition.

It should be noted that this embodiment does not exclude elements other than the above mentioned elements as p-type impurities and n-type impurities. In the following, an example case where the element A is Al (aluminum) and the element D is N (nitrogen) is described.

So as to set an appropriate threshold value in the MOSFET 200, the Al concentration in the p-SiC single-crystal layer 76 is preferably not lower than 1 × 10¹⁶ cm⁻³ and not higher than 5 × 10¹⁷ cm⁻³. The thickness of the p-SiC single-crystal layer 76 is not smaller than 0.3 µm and not greater than 1.0 µm, for example. The p-SiC single-crystal layer 76 functions as the channel region of the MOSFET 200.

An n⁻-type fourth SiC region (a JFET region) 17 containing the n-type impurity at an impurity concentration that is not lower than 5 × 10¹⁵ cm⁻³ and not higher than 1 × 10¹⁹ cm⁻³, for example, is formed in part of the surface of the p-SiC single-crystal layer 76. The depth of the JFET region 17 is equal to or greater than the thickness of the p-SiC single-crystal layer 76. The JFET region 17 is connected to the n⁻-SiC layer 14. The JFET region 17 functions as a transfer path for electrons serving as carriers.

An n⁺-type second SiC region (a source region) 18 containing the n-type impurity at an impurity concentration that is not lower than 1 × 10¹⁸ cm⁻³ and not higher than 1 × 10²² cm⁻³, for example, is formed in part of the surface of the p-SiC single-crystal layer 76. The depth of the source region 18 is smaller than the thickness of the p-SiC single-crystal layer 76, and is approximately 0.3 µm, for example. The source region 18 is located at a distance from the JFET region 17, with the p-SiC single-crystal layer 76 being interposed therebetween.

A p⁺-type third SiC region (a p-well contact region) 20 containing the p-type impurity at an impurity concentration that is not lower than 1 × 10¹⁸ cm⁻³ and not higher than 1 × 10²² cm⁻³, for example, is formed in part of the surface of the p-SiC single-crystal layer 76 and on a side of the source region 18. The depth of the p-well contact region 20 is smaller than the thickness of the p-SiC single-crystal layer 76, and is approximately 0.3 µm, for example.

Agate insulating film 28 is continuously formed on the surfaces of the JFET region 17 and the p-SiC single-crystal layer 76, so as to extend across those regions. The gate insulating film 28 may be a silicon oxide film (a SiO₂ film), a silicon oxynitride film, or a high-k insulating film, for example.

Agate electrode 30 is formed on the gate insulating film 28. The gate electrode 30 may be made of polysilicon, for example. An interlayer insulating film 32 formed with a SiO₂ film, for example, is formed on the gate electrode 30.

The p-SiC single-crystal layer 76 interposed between the source region 18 and the JFET region 17 under the gate electrode 30 functions as the channel region of the MOSFET 200.

A conductive first electrode (a source/p-well common electrode) 24 that is electrically connected to the source region 18 and the p-well contact region 20 is provided. The first electrode (the source/p-well common electrode) 24 is formed with a Ni (nickel) barrier metal layer 24a and an Al metal layer 24b formed on the barrier metal layer 24a, for example. The Ni barrier metal layer 24a and the Al metal layer 24b may form an alloy through a reaction.

A conductive second electrode (a drain electrode) 36 is formed on the side of the bottom surface of the SiC substrate 51. The second electrode (the drain electrode) 36 is made of Ni, for example.

In this embodiment, the n-type impurity is preferably N (nitrogen) or P (phosphorus), for example, but it is possible to use As (arsenic) or the like. Also, the p-type impurity is preferably Al (aluminum), for example, but it is possible to use B (boron), Ga (gallium), In (indium), or the like.

Next, a method of manufacturing the semiconductor device of this embodiment is described.

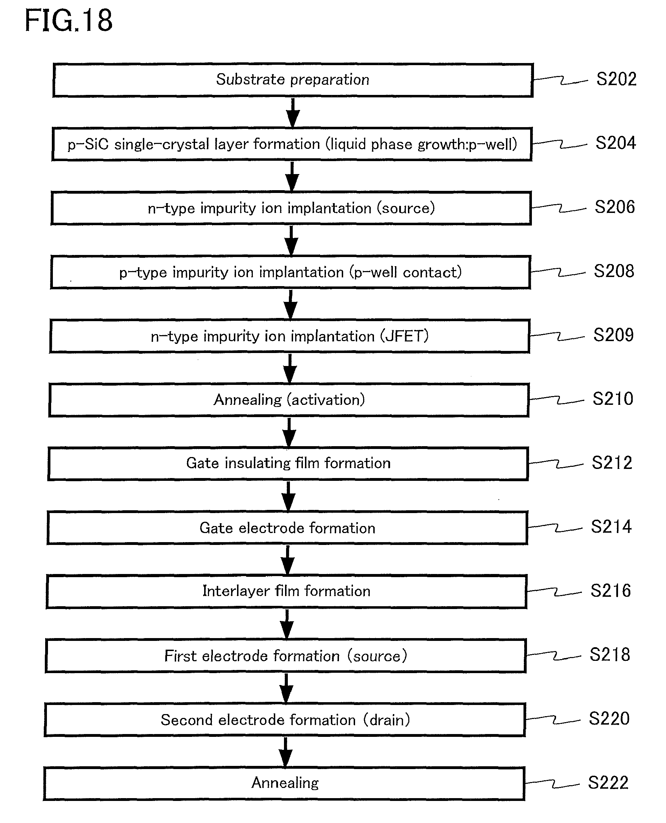

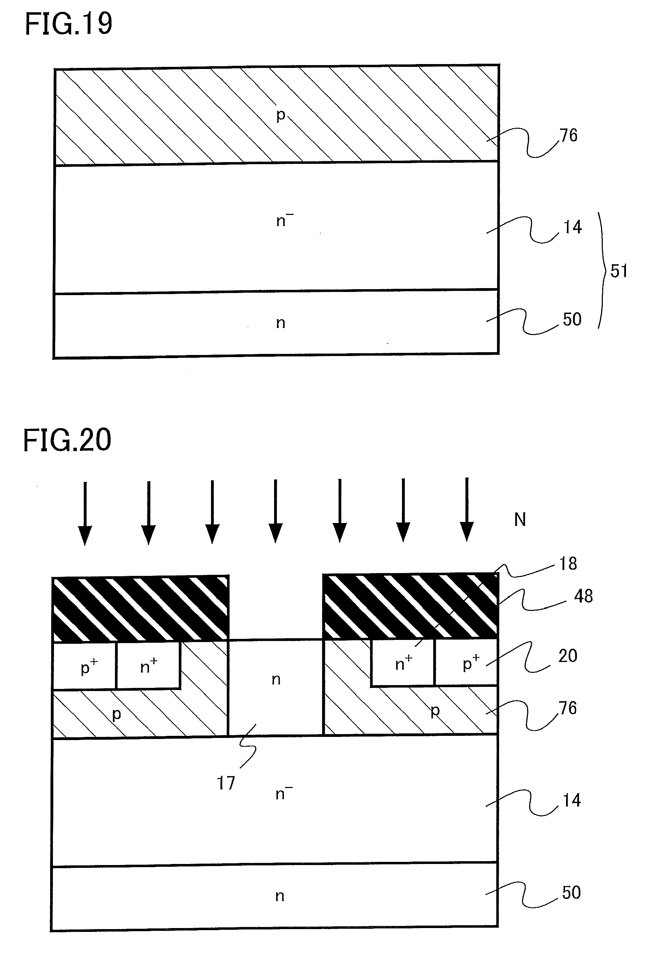

FIG. 18 is a flowchart showing the method of manufacturing the semiconductor device of this embodiment. FIGS. 19 and 20 are schematic cross-sectional views illustrating the method of manufacturing the semiconductor device of this embodiment.

As shown in FIG. 18, the method of manufacturing the semiconductor device includes: substrate preparation (step S202); p-SiC single-crystal layer formation (step S204); n-type impurity ion implantation (step S206); p-type impurity ion implantation (step S208); n-type impurity ion implantation (step S209); annealing (step S210); gate insulating film formation (step S212); gate electrode formation (step S214); interlayer film formation (step S216); first electrode formation (step S218); second electrode formation (step S220); and annealing (step S222).

First, in step S202, the 4H-SiC n-type SiC substrate (the n-SiC single-crystal substrate) 50 that contains P (phosphorus) or N (nitrogen) as the n-type impurity at an impurity concentration of approximately 5 × 10¹⁸ cm⁻³, has low resistance, and has a thickness of 300 µm, for example, is prepared.

The high-resistance n-type SiC epitaxial layer (the n⁻-SiC layer) 14 that contains N as the n-type impurity at an impurity concentration of approximately 1 × 10¹⁶ cm⁻³, for example, and has a thickness of approximately 10 µm is epitaxially grown on the surface of the n-SiC single-crystal substrate 50 by an epitaxial growth technique. In this manner, the substrate 51 having the n⁻-SiC layer 14 on the surface of the n-SiC single-crystal substrate 50 is prepared.

In step S204, the p-type SiC single-crystal layer (the p-SiC single-crystal layer) 76 is formed on the surface of the n⁻-SiC layer 14 through epitaxial growth by a liquid phase growth technique (FIG. 19). The p-SiC single-crystal layer 76 contains the p-type impurity and the n-type impurity. The method of forming the co-doped p-SiC single-crystal layer 76 by a liquid phase growth technique is the same as that of the first embodiment, except for the impurity ratio.

The surface of the n⁻-SiC layer 14 has an off angle that is not smaller than 0.5 degrees and not larger than 8 degrees with respect to the {0001} plane, for example. More preferably, the off angle is not smaller than 2 degrees and not larger than 6 degrees.

The Al concentration in the p-SiC single-crystal layer 76 is not lower than 1 × 10¹⁶ cm⁻³ and not higher than 5 × 10¹⁷ cm⁻³, for example. The concentrations of the p-type impurity and the n-type impurity in the p-SiC single-crystal layer 76 can be adjusted to desired values by controlling the concentrations of the p-type impurity and the n-type impurity in a liquid phase 1.

In step S206, the n⁺-type second SiC region (the source region) 18 is formed in the same manner as the second emitter region formation of the first embodiment. In step S208, the p⁺-type third SiC region (the p-well contact region) 20 is formed in the same manner as the emitter contact region formation of the first embodiment.

After that, patterning is performed by photolithography and etching, to form a mask material 48 made of SiO₂, for example. In step S209, ions of N as the n-type impurities are implanted into the p-type SiC single-crystal layer (the p-SiC single-crystal layer) 76 by using the mask material 48 as the ion implantation mask, to form the n-type fourth SiC region (the JFET region) 17 (FIG. 20).

That is, the n-type impurity at a higher concentration than the p-type impurity concentration in the p-well region 16 are implanted through ion implantation, to switch the conductivity types. The accelerating energy and the dose amount in the ion implantation are adjusted so that the depth of the fourth SiC region (the JFET region) 17 becomes equal to or greater than the thickness of the second SiC epitaxial layer.

In step S210, after the JFET region 17 is formed, annealing for activation is performed. The conditions for the annealing are that an argon (Ar) gas is used as the atmosphere gas, the heating temperature is 1600°C, and the heating period is 30 minutes, for example. At this point, the impurities implanted into the SiC can be activated, but diffusion is small.

In step S212, the gate insulating film 28 that is formed with a SiO₂ film, for example, is formed by CVD (Chemical Vapor Deposition) or thermal oxidation. In step S214, the gate electrode 30 that is made of polysilicon, for example, is formed on the gate insulating film 28. In step S216, the interlayer insulating film 32 that is formed with a SiO₂ film, for example, is formed on the gate electrode 30.

In step S218, the conductive first electrode (the source/p-well common electrode) 24 that is electrically connected to the source region 18 and the p-well contact region 20 is formed. The first electrode (the source/p-well common electrode) 24 is formed by Ni (nickel) and Al sputtering, for example.

In step S220, the conductive second electrode (the drain electrode) 36 is formed on the side of the bottom surface of the substrate 51. The second electrode (the drain electrode) 36 is formed by Ni sputtering, for example.

In step S222, annealing is performed to lower the contact resistance between the first electrode 24 and the second electrode 36. The annealing is performed in an argon gas atmosphere at 1000°C, for example.

By the above described manufacturing method, the MOSFET 200 shown in FIG. 17 is formed.

In this embodiment, the p-type SiC single-crystal layer (the p-SiC single-crystal layer: the p-well region) 76 is formed on the surface of the substrate 51 by using a liquid phase growth technique. With the liquid phase growth technique, TSDs are converted into basal plane dislocations (BPDs) in the p-SiC single-crystal layer 76. BPDs extend along the {0001} plane, and exit the p-SiC single-crystal layer 76 from a side surface. In this manner, the TSDs are restrained from reaching the surface of the p-SiC single-crystal layer 76. Accordingly, the reliability of the gate insulating film 28 formed on the surface of the p-SiC single-crystal layer 76 is increased.

In the MOSFET 200 manufactured by the manufacturing method according to this embodiment, the p-type SiC single-crystal layer (the p-SiC single-crystal layer: the p-well region) 76 is co-doped with Al and N. The ratio of the N concentration to the Al concentration is higher than 0.33 but lower than 1.0.

In this embodiment, the impurity concentrations in the p-SiC single-crystal layer 76 to be the channel region can be adjusted by impurity doping at the time of epitaxial growth. Accordingly, there is no need to implant ions into the channel region so as to adjust the threshold value of the MOSFET 200. As a result, defects due to ion implantation are not formed. Accordingly, electron scattering due to ion implantation defects does not occur. Thus, the electron mobility in the channel region becomes higher, and a sophisticated MOSFET is realized.

Also, as doping of the p-type impurity and the n-type impurity is performed at an appropriate ratio, trimer formation is facilitated. Accordingly, strain and defects in the channel region are reduced. Thus, the electron mobility in the channel region becomes higher, and the sophisticated MOSFET 200 is realized.

Also, the solid solubility limit of the p-type impurity becomes higher by virtue of the co-doping. As a result, the p-type impurity concentration in the channel region required to achieve a predetermined threshold value can be lower than that in a case where co-doping is not performed. Accordingly, electron scattering due to an impurity can be reduced. Thus, the electron mobility in the channel region becomes higher, and the sophisticated MOSFET 200 is realized.

So as to facilitate trimer formation and set an appropriate threshold value in the MOSFET 200, the concentration of the p-type impurity is preferably not lower than 1 × 10¹⁶ cm⁻³ and not higher than 5 × 10¹⁷ cm⁻³.

In this embodiment, the ratio of the concentration of the element D to the concentration of the element A in the formed p-SiC single-crystal layer 76 is preferably higher than 0.40 but lower than 0.95. This is because a high solid solubility limit of the p-type impurity can be secured. Also, the acceptor levels of the element A are preferably equal to or shallower than 150 meV. This is because the resistance of the channel region will become even lower, and the on-state current in the MOSFET 200 will increase. Further, 90% or more of the element D is preferably in the lattice site locations nearest to the element A. This is because most of the p-type impurity and the n-type impurity (90% or more of the impurities that can form trimers) will form trimers, and have a high solid solubility limit and a low resistance.

In the p-well contact region 20, the p-type impurity (Al) of the p-SiC single-crystal layer 76 exists in the background in the first place. Accordingly, the dose amount of the p-type impurity for the ion implantation for forming the p-well contact region 20 can be reduced. Thus, the ion implantation time can be shortened, and lattice damage due to ion implantation can be reduced.

Also, the crystal defects due to the thermal stress generated at the time of the annealing for activating the p-type impurity and at the time of the cooling after that, particularly basal plane dislocations, can be prevented from degrading the forward characteristics of the body diode of the MOSFET 200. Thus, a highly-reliable MOSFET is realized.

In the JFET region 17, the n-type impurity (N) of the p-SiC single-crystal layer 76 exists in the background in the first place. Accordingly, the dose amount of the n-type impurity for the ion implantation for forming the JFET region 17 can be reduced. Thus, the ion implantation time can be shortened, and lattice damage due to ion implantation can be reduced.

In a case where the p-type impurity (a second p-type impurity) is an element A while the n-type impurity (a second n-type impurity) is an element D in the JFET region 17, the element A and the element D preferably form a first combination that is at least one combination selected from Al (aluminum) and N (nitrogen), Ga (gallium) and N (nitrogen), and In (indium) and N (nitrogen), and/or a combination of B (boron) and P (phosphorus). The ratio of the concentration of the element A to the concentration of the element D in the first or second combination is preferably higher than 0.40 but lower than 0.95. This is because the trimer formation in the JFET region 17 will be facilitated, and a low-resistance n-layer with fewer defects will be realized. In this case, the concentration of the element D forming part of the above combination is preferably not lower than 1 × 10¹⁸ cm⁻³.

When the p-SiC single-crystal layer 76 is grown by a liquid phase growth technique, the p-type impurity and the n-type impurity coexist at the above described predetermined ratio in the liquid phase. Therefore, conversion of TSDs into BPDs during crystal growth is facilitated. Accordingly, TSDs can be prevented from extending into an upper layer from a layer with a smaller thickness than in a case where the p-SiC single-crystal layer 76 is formed by a vapor phase growth technique, for example. Also, with the same thickness, the concentration of TSDs that reach the surface can be reduced.

As described above, according to the method of manufacturing the semiconductor device of this embodiment, the p-SiC single-crystal layer 76 is formed by a liquid phase growth technique. Accordingly, dislocations in a semiconductor layer surface and in a semiconductor layer of the device can be reduced, and a highly-reliable MOSFET can be realized. Also, the p-SiC single-crystal layer 76 is co-doped with the p-type impurity and the n-type impurity at a predetermined ratio, so that electron mobility is increased, on-state resistance is lowered, and a high-performance MOSFET is realized.

Furthermore, the p-SiC single-crystal layer 76 is formed from a liquid phase co-doped with the p-type impurity and the n-type impurity at a predetermined ratio, so that conversion of TSDs into BPDs can be facilitated. Accordingly, the thickness of the p-SiC single-crystal layer 76 formed by liquid phase growth can be reduced, and productivity is increased. Also, conversion of TSDs into BPDs is facilitated, so that the concentration of dislocations that reach the surface can be lowered.

### (Third Embodiment)

A method of manufacturing a semiconductor device of this embodiment includes: preparing a substrate; and growing a p-type SiC single-crystal layer on the surface of the substrate from a liquid phase that contains Si (silicon), C (carbon), a p-type impurity, and an n-type impurity, the p-type impurity being an element A, the n-type impurity being an element D, the element A and the element D forming a first combination that is at least one combination selected from Al (aluminum) and N (nitrogen), Ga (gallium) and N (nitrogen), and In (indium) and N (nitrogen), and/or a second combination of B (boron) and P (phosphorus), the ratio of the concentration of the element D to the concentration of the element A in the first or second combination being higher than 0.33 but lower than 1.0, the concentration of the element A in the combination being not lower than 1 × 10¹⁶ cm⁻³ and not higher than 1 × 10²² cm⁻³.

More particularly, the substrate includes an n-type SiC layer and a p-type SiC layer on the n-type SiC layer. A SiC single-crystal layer is formed on the surface of the p-type SiC layer, a first electrode connected to the SiC single-crystal layer is formed, and a second electrode connected to the n-type SiC layer is formed.

Explanation of the same aspects as those of the function and effects of the liquid phase growth technique and the co-doping of the first or second embodiment will not be repeated.

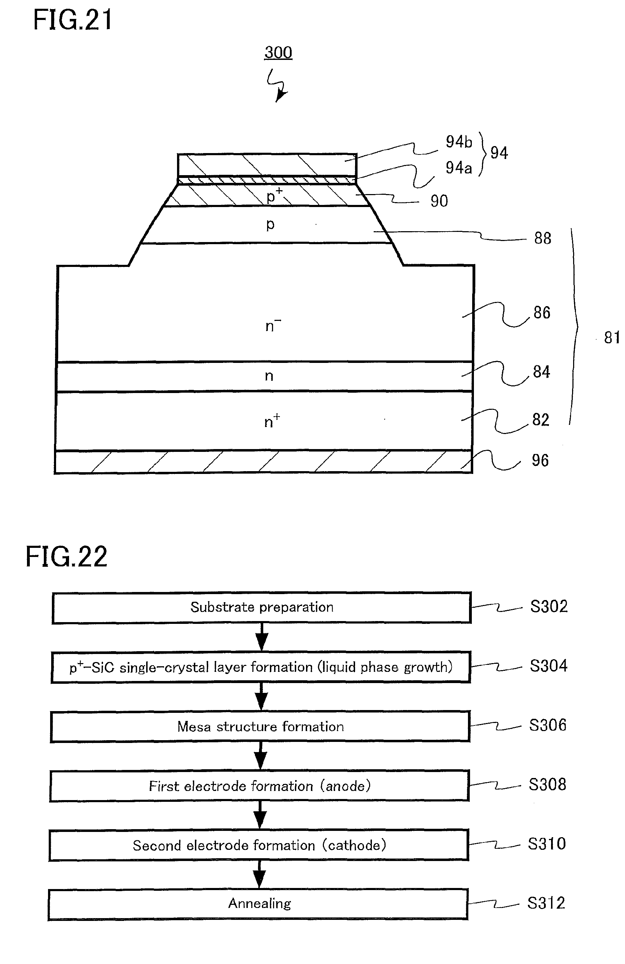

FIG. 21 is a schematic cross-sectional view of the semiconductor device to be manufactured in this embodiment. This semiconductor device is a mesa-type PiN diode.

This PiN diode 300 includes a substrate 81. The substrate 81 includes an n⁺-type SiC substrate (a silicon carbide substrate) 82. The SiC substrate 82 is a 4H-SiC substrate (an n-substrate) that contains N (nitrogen) as the n-type impurity, for example, at an impurity concentration of approximately 5 × 10¹⁸ to 1 × 10¹⁹ cm⁻³. The surface thereof is a plane inclined at 4 degrees to the {0001} plane, for example.

An n-type SiC layer (a buffer layer) 84 having a N concentration that is not lower than 1 × 10¹⁸ cm⁻³ and not higher than 5 × 10¹⁸ cm⁻³, for example, is formed on the surface of the SiC substrate 82. The thickness of the n-type SiC layer 84 is not smaller than 0.5 µm and not greater than 3 µm, for example.

An n⁻-type SiC layer 86 having a N impurity concentration that is not lower than 1 × 10¹⁵ cm⁻³ and not higher than 2 × 10¹⁶ cm⁻³, for example, is formed on the n-type SiC layer 84. The thickness of the n⁻-type SiC layer 86 is not smaller than 5 µm and not greater than 50 µm, for example.

A p-type SiC layer 88 having an Al impurity concentration that is not lower than 1 × 10¹⁷ cm⁻³ and not higher than 1 × 10¹⁸ cm⁻³, for example, is provided on the surface of the n⁻-type SiC layer 86. The p-type SiC layer 88 is co-doped with N (nitrogen) and Al (aluminum). The ratio of the N concentration to the Al concentration is higher than 0.33 but lower than 1.0. The thickness of the p-type SiC layer 88 is not smaller than 0.5 µm and not greater than 3 µm, for example.

A p-type SiC single-crystal layer (a p-SiC single-crystal layer) 90 formed by a liquid phase growth technique is provided on the surface of the p-type SiC layer 88. The p-SiC single-crystal layer 90 is co-doped with the p-type impurity and the n-type impurity. Where the p-type impurity is the element A and the n-type impurity is the element D, the element A and the element D form a combination of Al (aluminum), Ga (gallium), or In (indium) and N (nitrogen), and/or a combination of B (boron) and P (phosphorus). The ratio (concentration D/concentration A) of the concentration of the element D to the concentration of the element A in the above combination is higher than 0.33 but lower than 1.0. In the following, an example case where the element A is Al and the element D is N is described.

The Al concentration in the p-SiC single-crystal layer 90 is not lower than 1 × 10¹⁹ cm⁻³ and not higher than 1 × 10²² cm⁻³, for example. The thickness of the p-SiC single-crystal layer 90 is not smaller than 0.1 µm and not greater than 1 µm, for example.

A conductive anode electrode 94 that is electrically connected to the p-SiC single-crystal layer 90 is provided. The anode electrode 94 is formed with a Ni (nickel) barrier metal layer 94a and an Al metal layer 94b formed on the barrier metal layer 94a, for example.

A conductive cathode electrode 96 is formed on the side of the bottom surface of the n⁺-type SiC substrate 82. The cathode electrode 96 is made of Ni, for example.

Next, an example of a method of manufacturing the PiN diode 300 is described.

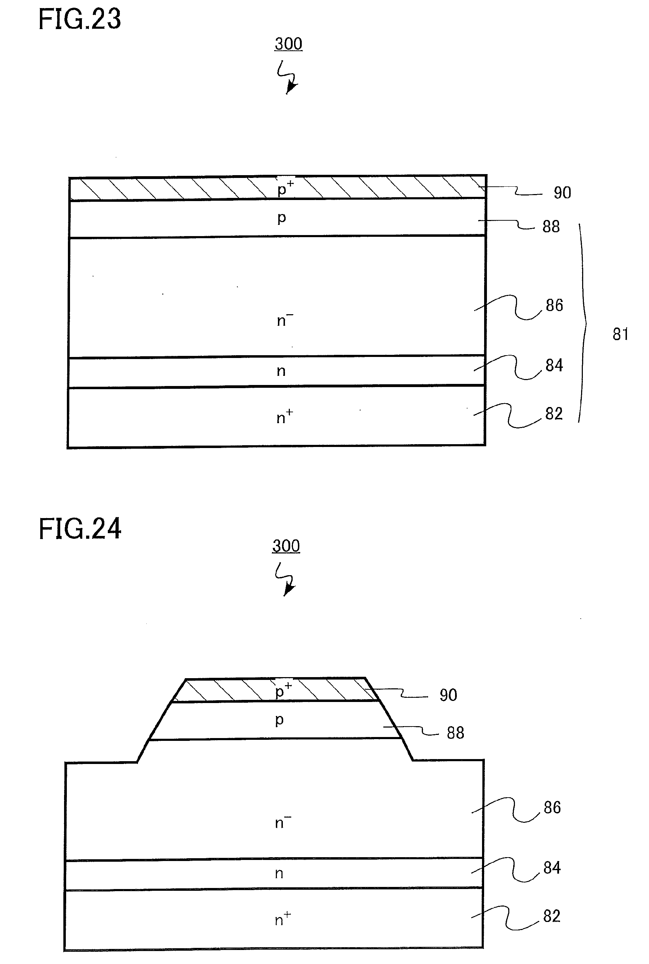

FIG. 22 is a flowchart showing an example of the method of manufacturing the semiconductor device of this embodiment. FIGS. 23 and 24 are schematic cross-sectional views illustrating the method of manufacturing the semiconductor device of this embodiment.

As shown in FIG. 22, the method of manufacturing the semiconductor device includes: substrate preparation (step S302); p⁺-SiC single-crystal layer formation (step S304); mesa structure formation (step S306); first electrode formation (step S308); second electrode formation (step S310); and annealing (step S312).

First, in step S302, the substrate 81 is prepared. The substrate 81 is formed by the manufacturing method described below, for example.

The n-type SiC layer 84 having a thickness of 1 µm, for example, is formed by epitaxial growth from a vapor phase on the n⁺-type SiC substrate 82 having an n-type impurity concentration of 5 × 10¹⁸ cm⁻³. The n⁻-type SiC layer 86 having a thickness of 40 µm, for example, is formed on the n-type SiC layer 84 by epitaxial growth from a vapor phase.

The p-type SiC layer 88 having a thickness of 1.5 µm, for example, is formed on the ntype SiC layer 86 by epitaxial growth from a vapor phase.

In step S304, the p⁺-type SiC single-crystal layer (p⁺-SiC single-crystal layer) 90 is formed on the surface of the p-type SiC layer 88 through epitaxial growth by a liquid phase growth technique (FIG. 23). The p⁺-SiC single-crystal layer 90 contains the p-type impurity and the n-type impurity. The method of forming the co-doped p⁺-SiC single-crystal layer 90 by a liquid phase growth technique is the same as that of the first embodiment, except for the substrate preparation.

The surface of the substrate 81 has an off angle that is not smaller than 0.5 degrees and not larger than 8 degrees with respect to the {0001} plane, for example. More preferably, the off angle is not smaller than 2 degrees and not larger than 6 degrees.

The Al concentration in the formed p⁺-SiC single-crystal layer 90 is not lower than 1 × 10¹⁹ cm⁻³ and not higher than 1 × 10²² cm⁻³, for example. The concentrations of the p-type impurity and the n-type impurity in the p⁺-SiC single-crystal layer 90 can be adjusted to desired values by controlling the concentrations of the p-type impurity and the n-type impurity in a liquid phase 1.

In step S306, the mesa structure is formed by a known process (FIG. 24). In step S308, the anode electrode 94 is formed by a known process. In step S310, the cathode electrode 96 is formed by a known process.

In step S310, annealing is performed to lower the contact resistance between the anode electrode 94 and the cathode electrode 96. The annealing is performed in an argon gas atmosphere at 1000°C, for example.

By the above described manufacturing method, the PiN diode 300 shown in FIG. 21 is formed.

In this embodiment, the p⁺-SiC single-crystal layer 90 is formed on the surface of the substrate 81 by using a liquid phase growth technique. With the liquid phase growth technique, TSDs are converted into basal plane dislocations (BPDs) in the p⁺-SiC single-crystal layer 90. BPDs extend along the {0001} plane, and exit the p⁺-SiC single-crystal layer 90 from a side surface. Accordingly, TSDs in the p⁺-SiC single-crystal layer 90 decrease. If there are TSDs, the reverse leakage current at the pn junction might become larger. According to this embodiment, the TSD density is lowered, so that reverse leakage current can be reduced.

In the PiN diode 300 manufactured by the manufacturing method according to this embodiment, the p⁺-SiC single-crystal layer 90 is co-doped with Al (aluminum) as the p-type impurity and N (nitrogen) as the n-type impurity at a predetermined ratio. With this arrangement, the resistance of the p⁺-SiC single-crystal layer 90 and the contact resistance of the anode electrode 94 are lowered. Accordingly, the forward current in the PiN diode 300 can be increased.

When the p-SiC single-crystal layer 90 is grown by a liquid phase growth technique, the p-type impurity and the n-type impurity coexist at the above described predetermined ratio in the liquid phase. Therefore, conversion of TSDs into BPDs during crystal growth is facilitated. Accordingly, TSDs can be prevented from extending into an upper layer from a layer with a smaller thickness than in a case where the p-SiC single-crystal layer 90 is formed by a vapor phase growth technique, for example. Also, with the same thickness, the density of TSDs that reach the surface can be reduced.

As described above, according to the method of manufacturing the semiconductor device of this embodiment, the p-SiC single-crystal layer 90 is formed by a liquid phase growth technique. Accordingly, dislocations in a semiconductor layer surface and in a semiconductor layer of the device can be reduced, and the PiN diode 300 with high reliability and high performance can be realized. As the p⁺-SiC single-crystal layer 90 is co-doped with the p-type impurity and the n-type impurity at a predetermined ratio, sheet resistance and contact resistance are lowered, and the PiN diode 300 with a large forward current can be realized. Furthermore, the p⁺-SiC single-crystal layer 90 is formed from a liquid phase co-doped with the p-type impurity and the n-type impurity at a predetermined ratio, so that conversion of TSDs into BPDs can be facilitated. Accordingly, the thickness of the p⁺-SiC single-crystal layer 90 formed by liquid phase growth can be reduced, and productivity is increased. Also, conversion of TSDs into BPDs is facilitated, so that the density of dislocations that reach the surface can be lowered.

### (Fourth Embodiment)

A method of manufacturing a semiconductor device of this embodiment includes: preparing a substrate; and growing an n-type SiC single-crystal layer on the surface of the substrate from a liquid phase that contains Si (silicon), C (carbon), a p-type impurity, and an n-type impurity, the p-type impurity being an element A, the n-type impurity being an element D, the element A and the element D forming a first combination that is at least one combination selected from Al (aluminum) and N (nitrogen), Ga (gallium) and N (nitrogen), and In (indium) and N (nitrogen), and/or a second combination of B (boron) and P (phosphorus), the ratio of the concentration of the element A to the concentration of the element D in the first or second combination being higher than 0.40 but lower than 0.95.

More particularly, an n-type SiC layer is formed on the surface of the SiC single-crystal layer through epitaxial growth, a p-type first SiC region is formed in the surface of the n-type SiC layer, an n-type second SiC region is formed in the surface of the first SiC region, a p-type third SiC region is formed in the surface of the first SiC region, a gate insulating film is formed on the surfaces of the SiC layer and the first SiC region, a gate electrode is formed on the gate insulating film, a first electrode connected to the second SiC region and the third SiC region is formed, and a second electrode connected to the SiC single-crystal layer is formed.

Explanation of the same aspects as those of the function and effects of the liquid phase growth technique and the co-doping of the first embodiment will not be repeated. Also, explanation of the same aspects as those of the semiconductor device and the method of manufacturing the semiconductor device of the first embodiment will not be repeated.

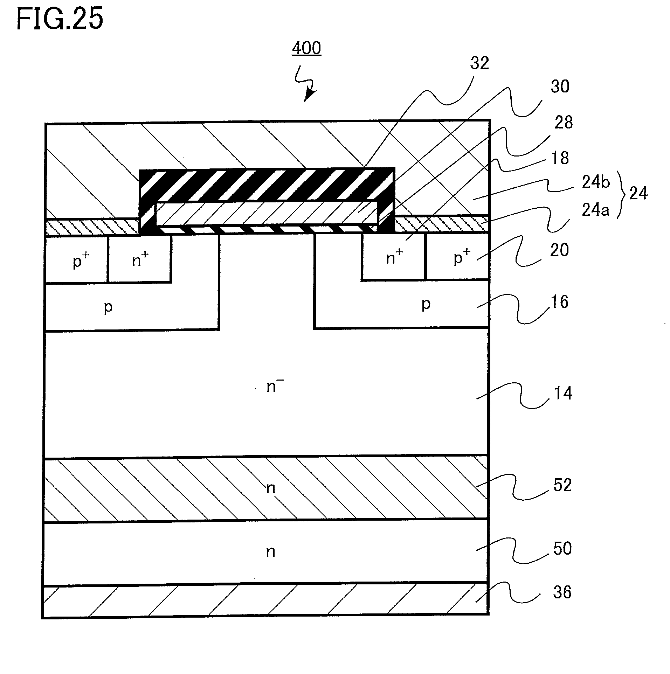

FIG. 25 is a schematic cross-sectional view of the structure of a MOSFET that is a semiconductor device of this embodiment. The MOSFET 400 is an n-type vertical MOSFET that has electrons as carriers.

This MOSFET 400 includes an n-type SiC substrate (an n-SiC single-crystal substrate) 50. The n-SiC single-crystal substrate 50 is a 4H-SiC substrate (an n-substrate) containing N (nitrogen) as the n-type impurity, for example, at an impurity concentration that is not lower than 1 × 10¹⁸ cm⁻³ and not higher than 1 × 10¹⁹ cm⁻³, for example.

An n-type SiC single-crystal layer (an n-SiC single-crystal layer) 52 formed by a liquid phase growth technique is provided on the surface of the n-SiC single-crystal substrate 50. The n-type SiC single-crystal layer 52 is co-doped with the p-type impurity and the n-type impurity. Where the p-type impurity is an element A and the n-type impurity is an element D, the element A and the element D form a first combination selected from Al (aluminum) and N (nitrogen), Ga (gallium) and N (nitrogen), and In (indium) and N (nitrogen), and/or a second combination of B (boron) and P (phosphorus). The ratio of the concentration of the element A to the concentration of the element D in the first or second combination is higher than 0.40 but lower than 0.95. In the following, an example case where the element A is Al and the element D is N is described.

The N (nitrogen) concentration in the n-SiC single-crystal layer 52 is not lower than 1 × 10¹⁸ cm⁻³ and not higher than 1 × 10²² cm⁻³, for example. The thickness of the n-SiC single-crystal layer 52 is not smaller than 1 µm and not greater than 350 µm, for example.

An n-type SiC layer (an n⁻-SiC layer) 14 containing the n-type impurity at an impurity concentration that is not lower than 5 × 10¹⁴ cm⁻³ and not higher than 2 × 10¹⁶ cm⁻³, for example, is formed on the surface of the n-SiC single-crystal layer 52. The thickness of the n⁻-SiC layer 14 is not smaller than 5 µm and not greater than 20 µm, for example.

A p-type first SiC region (a p-well region) 16 containing the p-type impurity at an impurity concentration that is not lower than approximately 5 × 10¹⁵ cm⁻³ and not higher than approximately 1 × 10¹⁷ cm⁻³, for example, is formed in part of the surface of the n⁻-SiC layer 14. The depth of the p-well region 16 is approximately 0.6 µm, for example. The p-well region 16 functions as the channel region of the MOSFET 400.

An n⁺-type first SiC region (a source region) 18 containing the n-type impurity at an impurity concentration that is not lower than 1 × 10¹⁸ cm⁻³ and not higher than 1 × 10²² cm⁻³, for example, is formed in part of the surface of the n⁻-SiC layer 14. The depth of the source region 18 is smaller than the depth of the p-well region 16, and is approximately 0.3 µm, for example.

A p⁺-type third SiC region (a p-well contact region) 20 containing the p-type impurity at an impurity concentration that is not lower than 1 × 10¹⁸ cm⁻³ and not higher than 1 × 10²² cm⁻³, for example, is formed in part of the surface of the p-well region 16 and on a side of the source region 18. The depth of the p-well contact region 20 is smaller than the depth of the p-well region 16, and is approximately 0.3 µm, for example.

A gate insulating film 28 is continuously formed on the surfaces of the n⁻-SiC layer 14 and the p-well region 16, so as to bridge the space between the layer and the region. The gate insulating film 28 may be a SiO₂ film or a high-k insulating film, for example.

A gate electrode 30 is formed on the gate insulating film 28. The gate electrode 30 may be made of polysilicon, for example. An interlayer insulating film 32 formed with a SiO₂ film, for example, is formed on the gate electrode 30.

The first SiC region 16 interposed between the second SiC regions (the source regions) 18 and the n⁻-SiC layer 14 under the gate electrode 30 functions as the channel region of the MOSFET 400.

A conductive first electrode (a source/p-well common electrode) 24 that is electrically connected to the source region 18 and the p-well contact region 20 is provided. The first electrode (the source/p-well common electrode) 24 is formed with a Ni (nickel) barrier metal layer 24a and an Al metal layer 24b formed on the barrier metal layer 24a, for example. The Ni barrier metal layer 24a and the Al metal layer 24b may form an alloy through a reaction.

A conductive second electrode (a drain electrode) 36 is formed on the side of the bottom surface of the SiC substrate 50. The second electrode (the drain electrode) 36 is made of Ni, for example.

In this embodiment, the n-type impurity is preferably N (nitrogen) or P (phosphorus), for example, but it is possible to use As (arsenic) or the like. Also, the p-type impurity is preferably Al (aluminum), for example, but it is possible to use B (boron), Ga (gallium), In (indium), or the like.

Next, a method of manufacturing the semiconductor device of this embodiment is described.

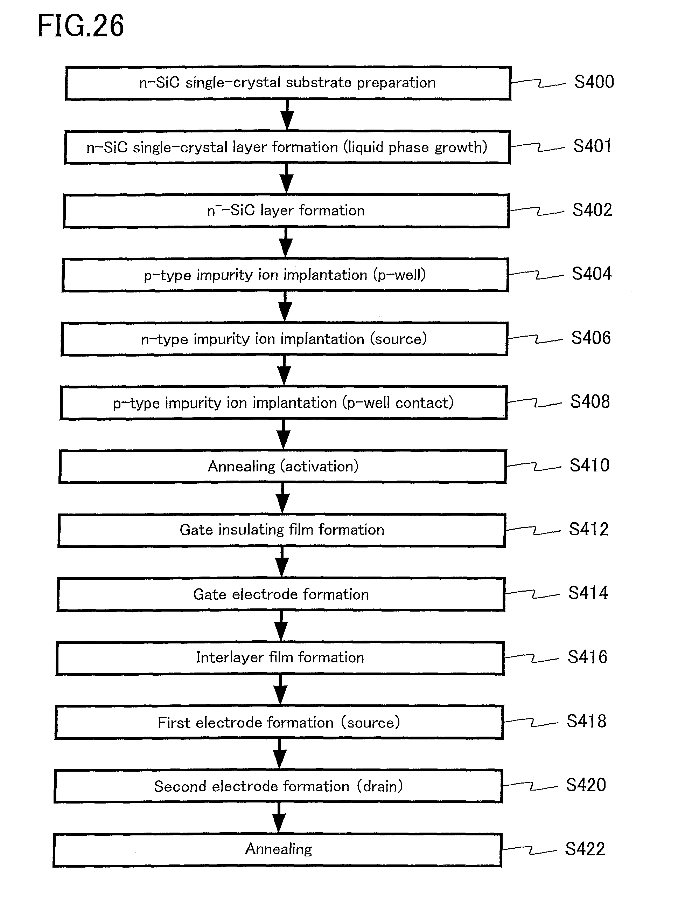

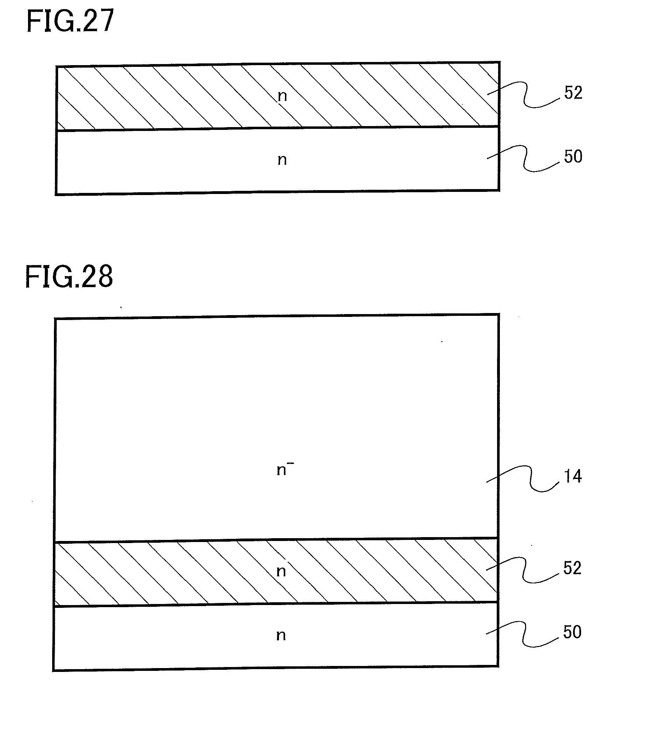

FIG. 26 is a flowchart showing an example of the method of manufacturing the semiconductor device of this embodiment. FIGS. 27, 28, and 29 are schematic cross-sectional views illustrating the method of manufacturing the semiconductor device of this embodiment.

As shown in FIG. 26, the method of manufacturing the semiconductor device includes: n-SiC single-crystal substrate preparation (step S400); n-SiC single-crystal layer formation by a liquid phase growth technique (step S401); n⁻-SiC layer formation (step S402); p-type impurity ion implantation (step S404); n-type impurity ion implantation (step S406); p-type impurity ion implantation (step S408); annealing (step S410); gate insulating film formation (step S412); gate electrode formation (step S414); interlayer film formation (step S416); first electrode formation (step S418); second electrode formation (step S420); and annealing (step S422).

First, in step S400, the 4H-SiC n-type SiC single-crystal substrate (the n-SiC single-crystal substrate) 50 that contains N (nitrogen) as the n-type impurity at an impurity concentration of approximately 5 × 10¹⁸ cm⁻³, has low resistance, and has a thickness of 200 µm, for example, is prepared.

In step S401, the n-type SiC single-crystal layer (the n-SiC single-crystal layer) 52 is formed on the surface of the n-SiC single-crystal substrate 50 through epitaxial growth by a liquid phase growth technique (FIG. 27). The surface of the n-SiC single-crystal substrate 50 has an off angle that is not smaller than 0.5 degrees and not larger than 8 degrees with respect to the {0001} plane, for example. More preferably, the off angle is not smaller than 2 degrees and not larger than 6 degrees.

The n-type SiC single-crystal layer 52 contains the p-type impurity and the n-type impurity. The method of forming the co-doped n-type SiC single-crystal layer 52 by a liquid phase growth technique is the same as that of the first embodiment, except for the impurity ratio.

In step S402, the high-resistance n⁻-SiC layer 14 that contains N as the n-type impurity at an impurity concentration of approximately 1 × 10¹⁶ cm⁻³, for example, and has a thickness of approximately 10 µm is grown on the surface of the n-SiC single-crystal layer 52 by an epitaxial growth technique (FIG. 28).

In step S404, the p-type first SiC region (the p-well region) 16 is formed in the same manner as the first emitter region formation of the first embodiment. In step S406, the n⁺-type second SiC region (the source region) 18 is formed in the same manner as the second emitter region formation of the first embodiment. In step S408, the p⁺-type third SiC region (the p-well contact region) 20 is formed in the same manner as the emitter contact region formation of the first embodiment.

In step S410, annealing for activation is performed. The conditions for the annealing are that an argon (Ar) gas is used as the atmosphere gas, the heating temperature is 1600°C, and the heating period is 30 minutes, for example. At this point, the impurities implanted into the SiC can be activated, but diffusion is small.

In step S412, the gate insulating film 28 that is formed with a SiO₂ film, for example, is formed by CVD (Chemical Vapor Deposition) or thermal oxidation. In step S414, the gate electrode 30 that is made of polysilicon, for example, is formed on the gate insulating film 28. In step S416, the interlayer insulating film 32 that is formed with a SiO₂ film, for example, is formed on the gate electrode 30.

In step S418, the conductive first electrode (the source/p-well common electrode) 24 that is electrically connected to the source region 18 and the p-well contact region 20 is formed. The first electrode (the source/p-well common electrode) 24 is formed by Ni (nickel) and Al sputtering, for example.

In step S420, the conductive second electrode (the drain electrode) 36 is formed on the side of the bottom surface of the substrate 51. The second electrode (the drain electrode) 36 is formed by Ni sputtering, for example.

In step S422, annealing is performed to lower the contact resistance between the first electrode 24 and the second electrode 36. The annealing is performed in an argon gas atmosphere at 1000°C, for example.

By the above described manufacturing method, the MOSFET 400 shown in FIG. 25 is formed.

In this embodiment, the n-SiC single-crystal layer 52 is formed on the surface of the n-SiC single-crystal substrate 50 by using a liquid phase growth technique. With the liquid phase growth technique, TSDs are converted into basal plane dislocations (BPDs) in the n-SiC single-crystal layer 52. BPDs extend along the {0001} plane, and exit the n-SiC single-crystal layer 52 from a side surface. In this manner, the TSDs are restrained from reaching the surface of the n--SiC layer 14. Accordingly, the reliability of the gate insulating film 28 formed on the surface of the n⁻-SiC layer 14 is increased.

The BPD density in the n⁻-SiC layer 14 can also be lowered. Accordingly, degradation of the forward characteristics of the body diode can be restrained. Thus, a highly-reliable MOSFET is realized.

In the MOSFET 400 of this embodiment, the n-SiC single-crystal layer 52 is co-doped with a p-type impurity such as Al and an n-type impurity such as N. With this arrangement, the sheet resistance and the resistivity of the n-SiC single-crystal layer 52 are lowered. Accordingly, a reduction in on-state resistance is achieved, and the high-performance MOSFET 400 is realized.

As trimers are formed, the crystalline structures are stabilized, and crystal defects are reduced. Accordingly, the MOSFET 400 having smaller leakage current is realized. Furthermore, as the crystalline structures are stabilized, the MOSFET 400 that has excellent energization breakdown tolerance is realized. That is, the MOSFET 400 is highly reliable against deterioration due to energization.

As for deterioration due to energization, there is a mode in which crystal defects having 3C structures are formed, and the resistance becomes higher. With the co-doped structure of this embodiment, the crystals are stable, and such a mode does not appear. Accordingly, the MOSFET 400 that does not cause the resistance increasing mode to appear can be formed.

The concentration of the n-type impurity contained in the n-SiC single-crystal layer 52 is preferably not lower than 1 × 10¹⁸ cm⁻³ and not higher than 1 × 10²² cm⁻³. This is also because, if the concentration is below the range, there is a possibility that interaction between the p-type impurity and the n-type impurity does not easily occur, and trimers are not formed. This is also because it is difficult to incorporate the n-type impurity having a concentration higher than the range.

So as to sufficiently lower sheet resistance or resistivity of the n-SiC single-crystal layer 52, the concentration of the n-type impurity contained in the n-SiC single-crystal layer 52 is preferably 1 × 10²⁰ cm⁻³ or higher.

In a case where the p-type impurity is the element A and the n-type impurity is the element D in the n-SiC single-crystal layer 52, the ratio of the concentration of the element A to the concentration of the element D is higher than 0.40 but lower than 0.95, so as to sufficiently lower the sheet resistance or the resistivity of the n-SiC single-crystal layer 52, and lower the on-state resistance. Also, the ratio of the concentration of the element A to the concentration of the element D is preferably not lower than 0.45 and not higher than 0.75. More preferably, the ratio is not lower than 0.47 and not higher than 0.60.

Therefore, the ratio of the concentration of the element A to the concentration of the element D in the liquid phase when the n-SiC single-crystal layer 52 is grown is higher than 0.40 but lower than 0.95. Also, the ratio of the concentration of the element A to the concentration of the element D is preferably not lower than 0.45 and not higher than 0.75. More preferably, the ratio is not lower than 0.47 and not higher than 0.60.

The ratio of the concentration of the element A to the concentration of the element D in the n-SiC single-crystal layer 52 can be calculated by determining the respective concentrations of the element A and the element D by SIMS (Secondary Ion Microprobe Spectrometry), for example.

In a case where the p-type impurity is the element A and the n-type impurity is the element D in the n-SiC single-crystal layer 52, the donor levels that contribute to generation of carriers of the element D are preferably 40 meV or shallower, so as to lower sheet resistance or resistivity. More preferably, the donor levels are 35 meV or shallower. Even more preferably, the donor levels are 20 meV or shallower.

The donor levels of the element D can be determined by measuring the activation energy of the sheet resistance or the resistivity of the n-SiC single-crystal layer 52, for example.

So as to sufficiently lower the sheet resistance or the resistivity of the n-SiC single-crystal layer 52, and realize low on-state resistance, most of the p-type impurity and the n-type impurity preferably forms trimers. Therefore, 90% or more of the element A is preferably in the lattice site locations nearest to the element D. If 90% or more of the element A is in the lattice site locations nearest to the element D, most of the p-type impurity and the n-type impurity (90% or more of the part that can form trimers) can be considered to form trimers.

The proportion of the element A in the lattice site locations nearest to the element D can be determined by analyzing the binding state between the element A and the element D by XPS (X-ray Photoelectron Spectroscopy), for example.

When the n-SiC single-crystal layer 52 is grown by a liquid phase growth technique, the p-type impurity and the n-type impurity coexist at the above described predetermined ratio in the liquid phase. Therefore, conversion of TSDs into BPDs during crystal growth is facilitated. Accordingly, TSDs can be prevented from extending into an upper layer from a layer with a smaller thickness than in a case where the n-SiC single-crystal layer 52 is formed by a vapor phase growth technique, for example. Also, with the same thickness, the density of TSDs that reach the surface can be reduced.

As described above, according to the method of manufacturing the semiconductor device of this embodiment, the n-SiC single-crystal layer 52 is formed by a liquid phase growth technique. Accordingly, dislocations in a semiconductor layer surface and in a semiconductor layer of the device can be reduced, and a highly-reliable MOSFET can be realized. Also, the n-SiC single-crystal layer 52 is co-doped with the p-type impurity and the n-type impurity at a predetermined ratio, so that on-state resistance is lowered, and a high-performance MOSFET is realized. Furthermore, the n-SiC single-crystal layer 52 is formed from a liquid phase co-doped with the p-type impurity and the n-type impurity at a predetermined ratio, so that conversion of TSDs into BPDs can be facilitated. Accordingly, the thickness of the n-SiC single-crystal layer 52 formed by liquid phase growth can be reduced, and productivity is increased. Also, conversion of TSDs into BPDs is facilitated, so that the density of dislocations that reach the surface can be lowered.

### (Fifth Embodiment)

A method of manufacturing a semiconductor device of this embodiment includes: preparing a substrate; and growing an n-type SiC single-crystal layer on the surface of the substrate from a liquid phase that contains Si (silicon), C (carbon), a p-type impurity, and an n-type impurity, the p-type impurity being an element A, the n-type impurity being an element D, the element A and the element D forming a first combination that is at least one combination selected from Al (aluminum) and N (nitrogen), Ga (gallium) and N (nitrogen), and In (indium) and N (nitrogen), and/or a second combination of B (boron) and P (phosphorus), the ratio of the concentration of the element A to the concentration of the element D in the first or second combination being higher than 0.40 but lower than 0.95.

More particularly, the substrate includes an n-type SiC layer, a SiC single-crystal layer is formed on the surface of the n-type SiC layer, a p-type first SiC region is formed in the surface of the SiC single-crystal layer, an n-type second SiC region is formed in the surface of the first SiC region, a p-type third SiC region is formed in the surface of the first SiC region, a gate insulating film is formed on the surfaces of the SiC layer and the first SiC region, a gate electrode is formed on the gate insulating film, a first electrode connected to the second SiC region and the third SiC region is formed, and a second electrode connected to the SiC layer is formed.

Explanation of the same aspects as those of the function and effects of the liquid phase growth technique and the co-doping of the first embodiment will not be repeated. Also, explanation of the same aspects as those of the semiconductor devices and the methods of manufacturing the semiconductor devices of the first through fourth embodiments will not be repeated.

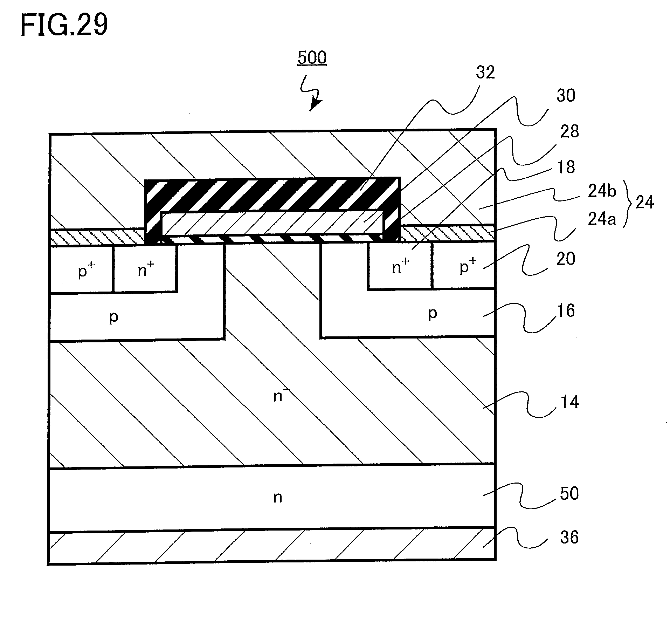

FIG. 29 is a schematic cross-sectional view of the structure of a MOSFET that is a semiconductor device of this embodiment. The MOSFET 500 is an n-type vertical MOSFET that has electrons as carriers.

This MOSFET 500 includes an n-type SiC substrate (an n-SiC single-crystal substrate) 50. The n-SiC single-crystal substrate 50 is a 4H-SiC substrate (an n-substrate) containing N (nitrogen) as the n-type impurity, for example, at an impurity concentration that is not lower than 1 × 10¹⁸ cm⁻³ and not higher than 1 × 10¹⁹ cm⁻³, for example.

An n-type SiC layer (an n⁻-SiC single-crystal layer) 14 formed by a liquid phase growth technique is provided on the surface of the n-SiC single-crystal substrate 50. The n⁻-SiC single-crystal layer 14 is co-doped with the p-type impurity and the n-type impurity. Where the p-type impurity is an element A and the n-type impurity is an element D, the element A and the element D form a combination of Al (aluminum), Ga (gallium), or In (indium) and N (nitrogen), and/or a combination of B (boron) and P (phosphorus). The ratio of the concentration of the element A to the concentration of the element D in the combination is higher than 0.40 but lower than 0.95. In the following, an example case where the element A is Al and the element D is N is described.

The N (nitrogen) concentration in the n⁻-SiC single-crystal layer 14 is not lower than 5 × 10¹⁵ cm⁻³ and not higher than 2 × 10¹⁶ cm⁻³, for example. The thickness of the n⁻-SiC single-crystal layer 14 is not smaller than 5 µm and not greater than 20 µm, for example.

A p-type first SiC region (a p-well region) 16 containing the p-type impurity at an impurity concentration that is not lower than approximately 5 × 10¹⁵ cm⁻³ and not higher than approximately 1 × 10¹⁷ cm⁻³, for example, is formed in part of the surface of the n⁻-SiC single-crystal layer 14. The depth of the p-well region 16 is approximately 0.6 µm, for example. The p-well region 16 functions as the channel region of the MOSFET 500.

An n⁺-type first SiC region (a source region) 18 containing the n-type impurity at an impurity concentration that is not lower than 1 × 10¹⁸ cm⁻³ and not higher than 1 × 10²² cm⁻³, for example, is formed in part of the surface of the n⁻-SiC single-crystal layer 14. The depth of the source region 18 is smaller than the depth of the p-well region 16, and is approximately 0.3 µm, for example.

A p⁺-type third SiC region (a p-well contact region) 20 containing the p-type impurity at an impurity concentration that is not lower than 1 × 10¹⁸ cm⁻³ and not higher than 1 × 10²² cm⁻³, for example, is formed in part of the surface of the p-well region 16 and on a side of the source region 18. The depth of the p-well contact region 20 is smaller than the depth of the p-well region 16, and is approximately 0.3 µm, for example.

A gate insulating film 28 is continuously formed on the surfaces of the n⁻-SiC single-crystal layer 14 and the p-well region 16, so as to bridge the space between the layer and the region. The gate insulating film 28 may be a SiO₂ film or a high-k insulating film, for example.

A gate electrode 30 is formed on the gate insulating film 28. The gate electrode 30 may be made of polysilicon, for example. An interlayer insulating film 32 formed with a SiO₂ film, for example, is formed on the gate electrode 30.

The first SiC region 16 interposed between the second SiC regions (the source regions) 18 and the n⁻-SiC single-crystal layer 14 under the gate electrode 30 functions as the channel region of the MOSFET 500.

A conductive first electrode (a source/p-well common electrode) 24 that is electrically connected to the source region 18 and the p-well contact region 20 is provided. The first electrode (the source/p-well common electrode) 24 is formed with a Ni (nickel) barrier metal layer 24a and an Al metal layer 24b formed on the barrier metal layer 24a, for example. The Ni barrier metal layer 24a and the Al metal layer 24b may form an alloy through a reaction.

A conductive second electrode (a drain electrode) 36 is formed on the side of the bottom surface of the SiC substrate 50. The second electrode (the drain electrode) 36 is made of Ni, for example.

In this embodiment, the n-type impurity is preferably N (nitrogen) or P (phosphorus), for example, but it is possible to use As (arsenic) or the like. Also, the p-type impurity is preferably Al (aluminum), for example, but it is possible to use B (boron), Ga (gallium), In (indium), or the like.

Next, a method of manufacturing the semiconductor device of this embodiment is described.

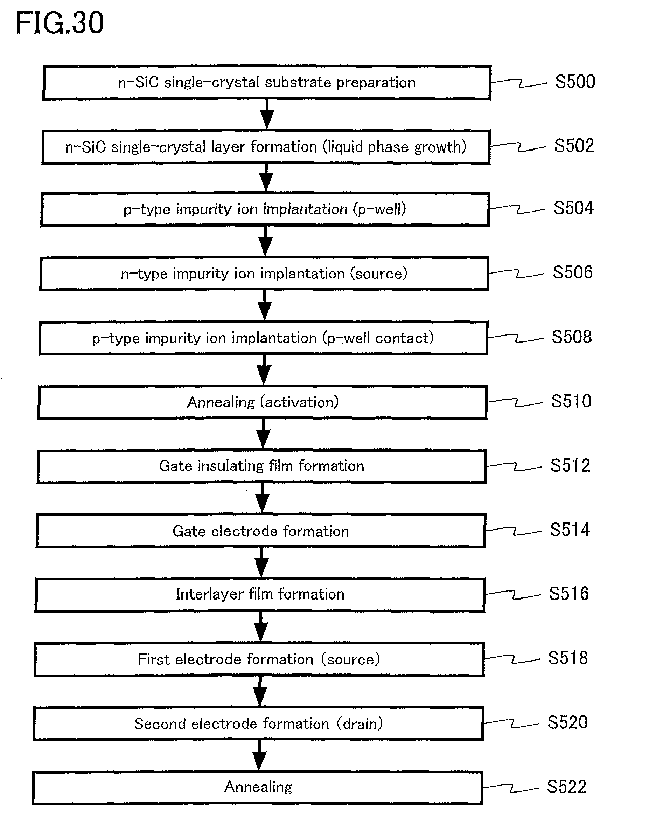

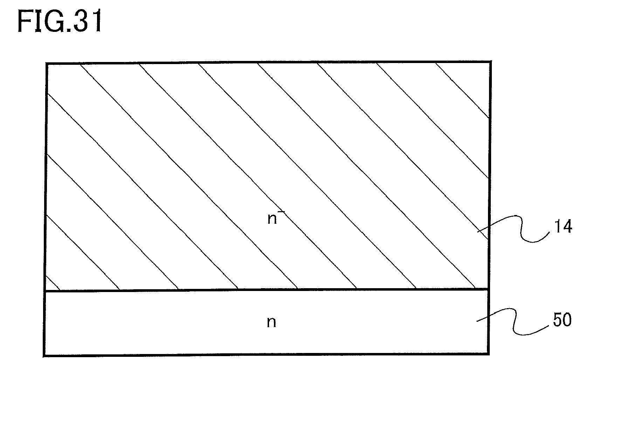

FIG. 30 is a flowchart showing an example of the method of manufacturing the semiconductor device of this embodiment. FIG. 31 is a schematic cross-sectional view illustrating the method of manufacturing the semiconductor device of this embodiment.

As shown in FIG. 30, the method of manufacturing the semiconductor device includes: n-SiC single-crystal substrate preparation (step S500); n⁻-SiC single-crystal layer formation by a liquid phase growth technique (step S502); p-type impurity ion implantation (step S504); n-type impurity ion implantation (step S506); p-type impurity ion implantation (step S508); annealing (step S510); gate insulating film formation (step S512); gate electrode formation (step S514); interlayer film formation (step S516); first electrode formation (step S518); second electrode formation (step S520); and annealing (step S522).

First, in step S500, the 4H-SiC n-type SiC single-crystal substrate (the n-SiC single-crystal substrate) 50 that contains N (nitrogen) as the n-type impurity at an impurity concentration of approximately 5 × 10¹⁸ cm⁻³, has low resistance, and has a thickness of 200 µm, for example, is prepared.

In step S502, the n-type SiC layer (the n⁻-SiC single-crystal layer) 14 is formed on the surface of the n-SiC single-crystal substrate 50 through epitaxial growth by a liquid phase growth technique (FIG. 31). The surface of the n-SiC single-crystal substrate 50 has an off angle that is not smaller than 0.5 degrees and not larger than 8 degrees with respect to the {0001} plane, for example. More preferably, the off angle is not smaller than 2 degrees and not larger than 6 degrees.

The n⁻-SiC single-crystal layer 14 contains the p-type impurity and the n-type impurity. The method of forming the co-doped n⁻-SiC single-crystal layer 14 by a liquid phase growth technique is the same as that of the first embodiment, except for the impurity ratio and concentrations.

The n⁻-SiC single-crystal layer 14 contains N as the n-type impurity at an impurity concentration of approximately 1 × 10¹⁶ cm⁻³, for example, and has a thickness of approximately 10 µm.

In step S504, the p-type first SiC region (the p-well region) 16 is formed in the same manner as the first emitter region formation of the first embodiment. In step S506, the n⁺-type second SiC region (the source region) 18 is formed in the same manner as the second emitter region formation of the first embodiment. In step S508, the p⁺-type third SiC region (the p-well contact region) 20 is formed in the same manner as the emitter contact region formation of the first embodiment.

In step S510, annealing for activation is performed. The conditions for the annealing are that an argon (Ar) gas is used as the atmosphere gas, the heating temperature is 1600°C, and the heating period is 30 minutes, for example. At this point, the impurities implanted into the SiC can be activated, but diffusion is small.

In step S512, the gate insulating film 28 that is formed with a SiO₂ film, for example, is formed by CVD (Chemical Vapor Deposition) or thermal oxidation. In step S514, the gate electrode 30 that is made of polysilicon, for example, is formed on the gate insulating film 28. In step S516, the interlayer insulating film 32 that is formed with a SiO₂ film, for example, is formed on the gate electrode 30.

In step S518, the conductive first electrode (the source/p-well common electrode) 24 that is electrically connected to the source region 18 and the p-well contact region 20 is formed. The first electrode (the source/p-well common electrode) 24 is formed by Ni (nickel) and Al sputtering, for example.

In step S520, the conductive second electrode (the drain electrode) 36 is formed on the side of the bottom surface of the substrate 51. The second electrode (the drain electrode) 36 is formed by Ni sputtering, for example.

In step S522, annealing is performed to lower the contact resistance between the first electrode 24 and the second electrode 36. The annealing is performed in an argon gas atmosphere at 1000°C, for example.

By the above described manufacturing method, the MOSFET 500 shown in FIG. 29 is formed.

In this embodiment, the n⁻-SiC single-crystal layer 14 is formed on the surface of the n-SiC single-crystal substrate 50 by using a liquid phase growth technique. With the liquid phase growth technique, TSDs are converted into basal plane dislocations (BPDs) in the n⁻-SiC single-crystal layer 14. BPDs extend along the {0001} plane, and exit the n⁻-SiC single-crystal layer 14 from a side surface. In this manner, the TSDs are restrained from reaching the surface of the n--SiC single-crystal layer 14. Accordingly, the reliability of the gate insulating film 28 formed on the surface of the n⁻-SiC single-crystal layer 14 is increased.

The BPD density in the n⁻-SiC single-crystal layer 14 can also be lowered. Accordingly, degradation of the forward characteristics of the body diode of the MOSFET 500 can be restrained. Thus, a highly-reliable MOSFET is realized.

In the MOSFET 500 of this embodiment, the n⁻-SiC single-crystal layer 14 is co-doped with a p-type impurity such as Al and an n-type impurity such as N. With this arrangement, the sheet resistance and the resistivity of the n⁻-SiC single-crystal layer 14 are lowered. Accordingly, a reduction in on-state resistance is achieved, and the high-performance MOSFET 500 is realized.

As trimers are formed, the crystalline structures are stabilized, and crystal defects are reduced. Accordingly, the MOSFET 500 having smaller leakage current is realized. Furthermore, as the crystalline structures are stabilized, the MOSFET 500 that has excellent energization breakdown tolerance is realized. That is, the MOSFET 500 is highly reliable against deterioration due to energization.

As for deterioration due to energization, there is a mode in which crystal defects having 3C structures are formed, and the resistance becomes higher. With the co-doped structure of this embodiment, the crystals are stable, and such a mode does not appear. Accordingly, the MOSFET 500 that does not cause the resistance increasing mode to appear can be formed.

In a case where the p-type impurity is the element A and the n-type impurity is the element D in the n⁻-SiC single-crystal layer 14, the ratio of the concentration of the element A to the concentration of the element D is higher than 0.40 but lower than 0.95, so as to sufficiently lower the sheet resistance or the resistivity of the n⁻-SiC single-crystal layer 14, and lower the on-state resistance. Also, the ratio of the concentration of the element A to the concentration of the element D is preferably not lower than 0.45 and not higher than 0.75. More preferably, the ratio is not lower than 0.47 and not higher than 0.60.

Therefore, the ratio of the concentration of the element A to the concentration of the element D in the liquid phase when the n⁻-SiC single-crystal layer 14 is grown is higher than 0.40 but lower than 0.95. Also, the ratio of the concentration of the element A to the concentration of the element D is preferably not lower than 0.45 and not higher than 0.75. More preferably, the ratio is not lower than 0.47 and not higher than 0.60.

The ratio of the concentration of the element A to the concentration of the element D in the n⁻-SiC single-crystal layer 14 can be calculated by determining the respective concentrations of the element A and the element D by SIMS (Secondary Ion Microprobe Spectrometry), for example.

In a case where the p-type impurity is the element A and the n-type impurity is the element D in the n⁻-SiC single-crystal layer 14, the donor levels that contribute to generation of carriers of the element D are preferably 40 meV or shallower, so as to lower sheet resistance or resistivity. More preferably, the donor levels are 35 meV or shallower. Even more preferably, the donor levels are 20 meV or shallower.

The donor levels of the element D can be determined by measuring the activation energy of the sheet resistance or the resistivity of the n⁻-SiC single-crystal layer 14, for example.

So as to sufficiently lower the sheet resistance or the resistivity of the n⁻-SiC single-crystal layer 14, and realize low on-state resistance, most of the p-type impurity and the n-type impurity preferably forms trimers. Therefore, 90% or more of the element A is preferably in the lattice site locations nearest to the element D. If 90% or more of the element A is in the lattice site locations nearest to the element D, most of the p-type impurity and the n-type impurity (90% or more of the part that can form trimers) can be considered to form trimers.

The proportion of the element A in the lattice site locations nearest to the element D can be determined by analyzing the binding state between the element A and the element D by XPS (X-ray Photoelectron Spectroscopy), for example.

When the n⁻-SiC single-crystal layer 14 is grown by a liquid phase growth technique, the p-type impurity and the n-type impurity coexist at the above described predetermined ratio in the liquid phase. Therefore, conversion of TSDs into BPDs during crystal growth is facilitated. Accordingly, TSDs can be prevented from extending into an upper layer from a layer with a smaller thickness than in a case where the n⁻-SiC single-crystal layer 14 is formed by a vapor phase growth technique, for example. Also, with the same thickness, the density of TSDs that reach the surface can be reduced.

As described above, according to the method of manufacturing the semiconductor device of this embodiment, the n⁻-SiC single-crystal layer 14 is formed by a liquid phase growth technique. Accordingly, dislocations in a semiconductor layer surface and in a semiconductor layer of the device can be reduced, and a highly-reliable MOSFET can be realized. Also, the nSiC single-crystal layer 14 is co-doped with the p-type impurity and the n-type impurity at a predetermined ratio, so that on-state resistance is lowered, and a high-performance MOSFET is realized. Furthermore, the n⁻-SiC single-crystal layer 14 is formed from a liquid phase co-doped with the p-type impurity and the n-type impurity at a predetermined ratio, so that conversion of TSDs into BPDs can be facilitated. Also, conversion of TSDs into BPDs is facilitated, so that the density of dislocations that reach the surface can be lowered.

Although silicon carbide crystalline structures are 4H-SiC in the above described embodiments, the embodiments can also be applied to silicon carbides having other crystalline structures such as 6H-SiC and 3C-SiC.

Although the substrate for forming a SiC single-crystal layer thereon by a liquid phase growth technique is a SiC substrate in each of the above described examples, a single-crystal substrate other than a SiC substrate can also be used, as long as epitaxial growth is possible on the single-crystal substrate.

While certain embodiments have been described, these embodiments have been presented by way of example only, and are not intended to limit the scope of the inventions. Indeed, a method of manufacturing a semiconductor device described herein may be embodied in a variety of other forms; furthermore, various omissions, substitutions and changes in the form of the devices and methods described herein may be made without departing from the spirit of the inventions. The accompanying claims and their equivalents are intended to cover such forms or modifications as would fall within the scope and spirit of the inventions.

## Claims

1. A method of manufacturing a semiconductor device, comprising
growing a p-type SiC single-crystal layer on a surface of a substrate from a liquid phase, the liquid phase containing Si (silicon), C (carbon), a p-type impurity, and an n-type impurity, the p-type impurity being an element A, the n-type impurity being an element D, the element A and the element D forming at least one of a first combination and a second combination, the first combination being at least one combination selected from Al (aluminum) and N (nitrogen), Ga (gallium) and N (nitrogen), and In (indium) and N (nitrogen), the second combination being B (boron) and P (phosphorus), a ratio of a concentration of the element D to a concentration of the element A in the first combination or in the second combination being higher than 0.33 but lower than 1.0.

2. The method according to claim 1, wherein the ratio of the concentration of the element D to the concentration of the element A is higher than 0.40 but lower than 0.95.

3. The method according to claim 1, further comprising:
forming an n-type SiC layer on a surface of the p-type SiC single-crystal layer through epitaxial growth;
forming a p-type first SiC region in a surface of the n-type SiC layer;
forming an n-type second SiC region in a surface of the p-type first SiC region;
forming a p-type third SiC region in the surface of the p-type first SiC region;
forming a gate insulating film on the surfaces of the n-type SiC layer and the p-type first SiC region;
forming a gate electrode on the gate insulating film;
forming a first electrode connected to the n-type second SiC region and the p-type third SiC region; and
forming a second electrode electrically connected to the p-type SiC single-crystal layer.

4. The method according to claim 1, wherein
the substrate includes an n-type SiC layer,
the p-type SiC single-crystal layer is formed on a surface of the n-type SiC layer, and the method further comprises:
forming an n-type second SiC region in a surface of the p-type SiC single-crystal layer;
forming a p-type third SiC region in the surface of the p-type SiC single-crystal layer;
forming an n-type fourth SiC region in the surface of the p-type SiC single-crystal layer, the p-type SiC single-crystal layer being interposed between the n-type second SiC region and the n-type fourth SiC region;
forming a gate insulating film on surfaces of the n-type fourth SiC region and the p-type SiC single-crystal layer;
forming a gate electrode on the gate insulating film;
forming a first electrode connected to the n-type second SiC region and the p-type third SiC region; and
forming a second electrode electrically connected to the n-type SiC layer.

5. The method according to claim 1, wherein
the substrate includes an n-type SiC layer, and a p-type SiC layer on the n-type SiC layer,
the p-type SiC single-crystal layer is formed on a surface of the p-type SiC layer, and
the method further comprises:
forming a first electrode connected to the p-type SiC single-crystal layer; and
forming a second electrode electrically connected to the n-type SiC layer.

6. A method of manufacturing a semiconductor device, comprising
growing an n-type SiC single-crystal layer on a surface of a substrate from a liquid phase, the liquid phase containing Si (silicon), C (carbon), a p-type impurity, and an n-type impurity, the p-type impurity being an element A, the n-type impurity being an element D, the element A and the element D forming at least one of a first combination and a second combination, the first combination being at least one combination selected from Al (aluminum) and N (nitrogen), Ga (gallium) and N (nitrogen), and In (indium) and N (nitrogen), the second combination being B (boron) and P (phosphorus), a ratio of a concentration of the element A to a concentration of the element D in the first combination or in the second combination being higher than 0.40 but lower than 0.95.

7. The method according to claim 6, wherein the ratio of the concentration of the element A to the concentration of the element D is not lower than 0.45 and not higher than 0.75.

8. The method according to claim 6, further comprising:
forming an n-type SiC layer on a surface of the n-type SiC single-crystal layer through epitaxial growth;
forming a p-type first SiC region in a surface of the n-type SiC layer;
forming an n-type second SiC region in a surface of the p-type first SiC region;
forming a p-type third SiC region in the surface of the p-type first SiC region;
forming a gate insulating film on the surfaces of the n-type SiC layer and the p-type first SiC region;
forming a gate electrode on the gate insulating film;
forming a first electrode connected to the n-type second SiC region and the p-type third SiC region; and
forming a second electrode electrically connected to the n-type SiC single-crystal layer.

9. The method according to claim 6, wherein
the substrate includes an n-type SiC layer,
the n-type SiC single-crystal layer is formed on a surface of the n-type SiC layer, and
the method further comprises:
forming a p-type first SiC region in a surface of the n-type SiC single-crystal layer;
forming an n-type second SiC region in a surface of the p-type first SiC region;
forming a p-type third SiC region in the surface of the p-type first SiC region;
forming a gate insulating film on the surfaces of the n-type SiC layer and the p-type first SiC region;
forming a gate electrode on the gate insulating film;
forming a first electrode connected to the n-type second SiC region and the p-type third SiC region; and
forming a second electrode electrically connected to the n-type SiC layer.
